# EUROPÄISCHE PATENTSCHRIFT

(11) **EP 4 341 201 B1**
(45) Veröffentlichungstag und Bekanntmachung des Hinweises auf die Patenterteilung: **11.03.2026**
(21) Anmeldenummer: 22721851.8
(22) Anmeldetag: 14.04.2022
(51) Int. Cl.: B81B 3/00

(54) **STRESSKONFIGURIERBARE NANOELEKTRONISCHE BAUELEMENTSTRUKTUR SOWIE ZWISCHENPRODUKT UND VERFAHREN ZUR HERSTELLUNG EINER NANOELEKTRONISCHEN BAUELEMENTSTRUKTUR**
STRESS-CONFIGURABLE NANOELECTRONIC COMPONENT STRUCTURE, INTERMEDIATE PRODUCT, AND METHOD FOR PRODUCING A NANOELECTRONIC COMPONENT STRUCTURE
STRUCTURE DE COMPOSANT NANOÉLECTRONIQUE À CONTRAINTE CONFIGURABLE, PRODUIT INTERMÉDIAIRE ET PROCÉDÉ DE PRODUCTION DE STRUCTURE DE COMPOSANT NANOÉLECTRONIQUE

(30) Priorität: 18.05.2021 DE 102021112863
(43) Veröffentlichungstag der Anmeldung: 27.03.2024
(73) Patentinhaber: Technische Universität Chemnitz, 09111 Chemnitz (DE)
(72) Erfinder: HERMANN, Sascha, 09126 Chemnitz (DE); BÖTTGER, Simon, 09405 Gornau (DE); PANKENIN, Eric, 09120 Chemnitz (DE)
(74) Vertreter: Steiniger, Carmen
(86) Internationale Anmeldenummer: PCT/IB2022/053524
(87) Internationale Veröffentlichungsnummer: WO 2022/243761

(56) Entgegenhaltungen:
- DE-A1- 102012 008 251
- BONITZ JENS ET AL: "Wafer-level technology for integration of carbon nanotubes into micro-electro-mechanical systems", 2016 IEEE 11TH ANNUAL INTERNATIONAL CONFERENCE ON NANO/MICRO ENGINEERED AND MOLECULAR SYSTEMS (NEMS), IEEE, 17 April 2016 (2016-04-17), pages 595 - 599, XP033013785, DOI: 10.1109/NEMS.2016.7758322

## Beschreibung

Die vorliegende Erfindung betrifft ein Zwischenprodukt zur Herstellung einer nanoelektronischen Bauelementstruktur, wobei das Zwischenprodukt ein Substrat, wenigstens eine in dem Substrat ausgebildete Kavität und wenigstens eine die jeweilige Kavität zumindest teilweise überspannende Nanostruktur aufweist. Die Erfindung betrifft ferner eine nanoelektronische Bauelementstruktur, die ein Substrat, wenigstens eine in dem Substrat ausgebildete Kavität und wenigstens eine die jeweilige Kavität zumindest teilweise überspannende Nanostruktur aufweist. Zudem betrifft die Erfindung ein Verfahren zum Herstellen einer nanoelektronischen Bauelementstruktur, bei dem in ein Substrat wenigstens eine Kavität eingebracht wird und die jeweilige Kavität mit wenigstens einer Nanostruktur überbrückt wird.

Die moderne Elektronik fordert materialseitig immer mehr Funktionalität bei reduziertem Platz- und Energiebedarf, um den Ansprüchen der heutigen Gesellschaft und Industrie zu genügen.

Dabei sind 1D- und 2D-Nanomaterialien bzw. darauf basierende Nanostrukturen aufgrund Ihrer zumeist außergewöhnlichen intrinsischen Eigenschaften wie Dimensionalität, Belastbarkeit, elektronischen Eigenschaften, höchster Sensitivität und Güte bei reduzierter Energiedissipation prädestiniert, um hier eingesetzt zu werden.

Graphen, eine Modifikation des Kohlenstoffs mit zweidimensionaler Struktur, in der jedes Kohlenstoffatom im Winkel von 120° von drei weiteren umgeben ist, sodass sich ein bienenwabenförmiges Muster ausbildet, ist zurzeit das begehrteste und am meisten studierte Nanomaterial. Aus der Klasse der 1D-Nanomaterialien sind beispielsweise Nanoröhren, d. h. längliche Hohlkörper mit weniger als 100 nm Durchmesser, im Einsatz. Bekannt und gut untersucht sind hierbei beispielsweise Kohlenstoffnanoröhren. Ebenso gibt es Nanodrähte aus Silizium und verschiedenen anderen Materialien.

Mittlerweile findet man beispielsweise eindimensionale Nanostrukturen, wie z. B. Kohlenstoffnanoröhren, in verschiedensten industrierelevanten Applikationen wie in Sensoren, Hochfrequenz-Transceivern, nichtflüchtigen Speichern, digitalen Architekturen und Sicherheitsprimitiven für Hardware. Für viele dieser Anwendungen mangelt es jedoch noch an geeigneten skalierbaren und reproduzierbaren Integrationstechnologien, um die vorher erwähnten hervorragenden Eigenschaften innerhalb von Domänen konstanter physikalischer Struktur und Ausrichtung der Nanomaterialien, wobei die jeweilige Ausdehnung einer Domäne im ein- bis zweistelligen Mikrometerbereich liegt, flächendeckend nutzbar zu machen. Repräsentativ für den prägnanten Einfluss von mechanischen Spannungszuständen sind die außerordentlich hohen Sensitivitätsfaktoren für ausgewählte Domänenstrukturen piezoresistiver Sensoren aus Nanomaterialien. Diese sind zumeist nur in Einzelbauelementen gemessen, aber aufgrund unzureichender Vergleichbarkeit der Domänen untereinander noch nicht in hoher Stückzahl gefertigt worden.

Hier kann es beispielsweise unter undefinierten Spannungs- und strukturellen Assemblierungszuständen der Nanomaterialien zum Auftreten von parasitären Oberflächenverzerrungen oder Effekten wie einem Slip-Stick-Verhalten in ein- und zweidimensionalen piezoresistiven Sensoren oder Nanoresonatoren kommen, welche zur Degradation des Leistungsverhaltens, wie etwa zu Hysterese, Drift und erhöhter Varianz der Bauteileigenschaften, wie z. B. Bandlücken, Ladungsträgermobilität und/oder Resonanzfrequenzen, führen. Die Oberflächenverzerrungen verhindern beispielsweise einen homogenen und faltenfreien Übertrag von Graphen auf ein Zielsubstrat und beeinträchtigen außerdem die elektrischen Eigenschaften, indem lokal die elektronische Materialstruktur verändert wird.

Neben den genannten parasitären Effekten war es auch aufgrund des geringen Flächenträgheitsmomentes der Nanomaterialien bisher nicht möglich, mechanische Druckspannung mittels piezoresistiver Sensoren aus Nanomaterial zu detektieren. Erschwerend hinzu kommt ebenfalls die intrinsische Variabilität der Nanomaterialien, aufgrund unterschiedlicher Assemblierungssymmetrie für zweidimensionale Nanostrukturen und der Chiralität für eindimensionale Nanostrukturen, welche von Natur aus eine Variabilität der elektronischen Eigenschaften bedingt. Ursächlich hat dies in der Vergangenheit eine Realisierung von typischen Kompensationsschaltungen wie Halb- oder Vollbrücken behindert.

Nanomaterialien haben unbestritten ein enormes Potenzial, um die "Beyond-CMOS"-Ära auf Basis neuartiger Elektronikkonzepte, wie etwa der 3D-Hyperintegration, entscheidend zu prägen. Es fehlt jedoch momentan an kontrollierbaren, skalierbaren und reproduzierbaren Integrationstechnologien, in welchen beispielsweise eine Kontrolle des mechanischen Verspannungszustandes von Nanostrukturen möglich ist.

Es gibt im Stand der Technik Ansätze, um den mechanischen Verspannungszustand von Nanomaterialien gezielt einzustellen oder zu beeinflussen.

So kann durch bestimmte Oberflächentechnologien eine dauerhafte Verspannung hergestellter Nanomaterial-Bauteile eingestellt werden.

Beispielsweise ist es grundsätzlich denkbar, auf Nanomaterialien, wie es aus der konventionellen Silizium-basierten MOSFET-Technologie bekannt ist, als Stressoren fungierende Deckschichten aufzubringen und gegebenenfalls zu strukturieren. Dies ist jedoch mit enormen Herausforderungen hinsichtlich der Prozesskompatibilität verbunden, sodass sich hierzu keine Veröffentlichungen finden.

Ferner sind Technologien bekannt, bei welchen die jeweilige Nanomaterial-Zone freigestellt und nachfolgend modifiziert wird, um eine feste Verspannung zu realisieren.

Zudem ist es möglich, direkt während der Nanomaterialintegration eine Vorspannung in das Nanomaterial einzubringen. Hierzu kann eine Transfer-Trägermembran genutzt werden, die bei dem Übertrag des Nanomaterials auf die auszubildende Struktur mechanisch gedehnt wird. Mit einer solchen Technologie kann jedoch weder lokal variabel noch multidirektional eine Spannung in das Nanomaterial eingebracht werden.

Darüber hinaus kann eine temporäre lokale Modifikation des Verspannungszustandes von aufgespannten Nanomaterialien vorgenommen werden, indem beispielsweise eine Sonde oder eine direkt auf der betreffenden Probe gefertigte, bewegliche MEMS-Aktorik zum Einsatz kommen. Solche Bauelemente sind jedoch aufgrund der hohen Komplexität und des hohen Anspruchs bei Fertigungstechnologien und Betriebsbedingungen lediglich für Einzelbauelementuntersuchungen nicht aber für eine skalierbare Umsetzung in industrierelevante Applikationen geeignet.

Um z. B. mit sondenmikroskopischen Verfahren den Verspannungszustand von Nanomaterialien lokal zu modifizieren, ist ein immens hoher Einsatz von nachgelagerter Steuerelektronik und peripherer Systeme, z. B. zur Schwingungsdämpfung, erforderlich. Außerdem sind hierbei Effekte, welche durch die Verspannung oder die Deformation des Nanomaterials an der Sonde bewirkt werden, und Streufelder der Sonde nicht mehr klar voneinander unterscheidbar.

Thermische oder elektrostatische MEMS-Aktoren, die mit integrierten Nanomaterialien kombiniert werden, sind im Vergleich zum jeweiligen Nanobauelement mit einem extremen Platzbedarf und einer ressourcenintensiven MEMS-Technologie verbunden und damit nicht für die Serienfertigung skalierbar einsetzbar. Außerdem ist die Verspannung der Nanomaterialien in diesen Bauelementen ohne weitere Anstrengungen stark anfällig gegenüber Vibrationen und Inertialbewegungen und unter Umständen wird zusätzliche Energie zum Betrieb des Aktors benötigt. Das Wirkprinzip der Aktoren bringt zusätzlich parasitäre Effekte wie Potential- und/oder Temperaturgradienten in das System ein.

Ferner kann zum Induzieren einer mechanischen Verspannung ein auf oder an einer eine Kavität überspannenden Membran aus Nanomaterial platziertes Gewicht zum Einsatz kommen oder eine Druckdifferenz zwischen einer Membran aus Nanomaterial und einem von dieser Membran in einer Kavität eingeschlossenen Gas-, Fluid- oder Festkörpervolumen ausgebildet werden. Abgesehen vom technologischen und aktorischen Mehraufwand sowie vergleichsweise großem Platzbedarf und damit begrenzter Skalierbarkeit sind bei solchen Anordnungen die Verspannungsrichtungen meist in alle Raumrichtungen verteilt, sodass eine örtlich sehr präzise Platzierung des Nanomaterials zur Sicherstellung der eingeprägten Spannungszustände erforderlich wäre.

Zusammenfassend sind bisher keine Nanomaterial-Bauelemente demonstriert worden, welche in einer skalierbaren, parallelen Fertigung auf Wafer-Niveau hergestellt wurden und gleichzeitig spannungszustandsabhängige intrinsische Effekte innerhalb einer Nanomaterial-Domänengrenze oder von verschiedenen Nanostrukturen mit hoher Flächendichte gezielt steuerbar und skalierbar zugänglich machen. Vielmehr sind technologisch höchst aufwändige und ressourcenintensive Ansätze wie MEMS-Technologien oder Sondenmanipulation an größtenteils Einzelteilen gezeigt worden. Diese Ansätze erfordern aber einen vergleichsweise großen Platzbedarf für die Manipulationswerkzeuge der Nanoobjekte. BONITZ JENS ET AL: "Wafer-level technology for integration of carbon nanotubes into micro-electro-mechanical systems", 2016 IEEE 11TH ANNUAL INTERNATIONAL CONFERENCE ON NANO/MICRO ENGINEERED AND MOLECULAR SYSTEMS (NEMS), IEEE, 17. April 2016 (2016-04-17), Seiten 595-599, DOI: 10.1109/ NEMS.2016.7758322 offenbart eine piezoresistive mechanische Vorrichtung auf SWCNT-Basis. Ein SWCNT ist zur Fixierung und elektrischen Verbindung in Metallelektroden eingebettet. Eine Auslenkung der beweglichen Struktur wird durch eine entsprechende Widerstandsänderung des SWCNTs detektiert. Die Vorrichtung verfügt über einen Aktuator. Zur Herstellung der Vorrichtung wird in einem ersten Schritt der Aktuatorbereich durch einen Standard-RIE-Prozess strukturiert, während der CNT-Kontaktbereich noch geschützt ist. Anschließend wird das verbleibende Silizium durch einen isotropen Trockenätzprozess entfernt, der das seitliche Unterätzen der CNT-Kontaktbereiche umfasst. In der resultierenden Struktur wird der Spalt zwischen dem beweglichen und dem festen Teil durch eine Passivierungsschicht aus SiO2 überbrückt, die ein SWCNT enthält. Im letzten Schritt werden die CNT-Passivierung und die vergrabene Oxidschicht durch Fluorwasserstoff-Gasphasenätzen entfernt, um die beweglichen Strukturen und die Elektroden-CNT-Stellen freizulegen.

Es ist daher die Aufgabe der vorliegenden Erfindung, eine mit bestehenden Integrationstechnologien herstellbare nanoelektronische Bauelementstruktur mit definiert einstellbarer mechanischer Verspannung und gegebenenfalls ein Zwischenprodukt für deren Herstellung zur Verfügung zu stellen. Ferner soll ein Verfahren zur Herstellung einer hinsichtlich ihrer mechanischen Verspannung einstellbaren nanoelektronischen Bauelementstruktur vorgeschlagen werden, das zu bestehenden Integrationstechnologien kompatibel ist.

Diese Aufgabe wird zum einen erfindungsgemäß durch ein Zwischenprodukt zur Herstellung einer nanoelektronischen Bauelementstruktur gelöst, wobei das Zwischenprodukt ein Substrat, wenigstens eine in dem Substrat ausgebildete Kavität und wenigstens eine die jeweilige Kavität zumindest teilweise überspannende Nanostruktur aufweist, wobei die Kavität zumindest teilweise mit einem selektiv zum Material des Substrates ätz- oder auflösbaren Opfermaterial gefüllt ist und das Zwischenprodukt entweder wenigstens einseitig der jeweiligen Kavität wenigstens einen die wenigstens eine Kavität nur teilweise überspannenden Ausleger aufweist, so dass über der wenigstens einen Kavität eine Lücke ausgebildet ist, oder wenigstens einen die Kavität überspannenden Ausleger mit einer über der wenigstens einen Kavität ausgebildeten Sollbruchstelle aufweist, wobei die wenigstens eine Nanostruktur auf dem wenigstens einen Ausleger, jeweils die Lücke oder die Sollbruchstelle überspannend angeordnet ist und jeweils beidseitig der Lücke oder der Sollbruchstelle von jeweils einer Kontaktelektrode überdeckt ist.

Aus dem erfindungsgemäßen Zwischenprodukt ist die Ausbildung einer nanoelektronischen Bauelementstruktur mit lokal kontrollierbaren bzw. lokal einstellbaren mechanischen Spannungszuständen möglich.

Hierfür weist das Zwischenprodukt das Substrat auf, in dem die wenigstens eine, jeweils mit dem Opfermaterial gefüllte Kavität ausgebildet ist. Das Substrat kann beispielsweise aus Silizium oder einem anderen Halbleitermaterial ausgebildet sein. In, auf oder unter dem Substrat können auch andere mikroelektronische und/oder mikromechanische Strukturen, wie elektrische Anschlüsse, Elektroden, Kanäle, Membranen usw., vorgesehen sein.

Das Opfermaterial bildet bei dem erfindungsgemäßen Zwischenprodukt eine geeignete Grundlage zur Abscheidung des wenigstens einen Auslegers und zur Aufbringung der wenigstens einen Nanostruktur. Zudem kann der jeweilige auf dem Opfermaterial befindliche Ausleger darauf gut strukturiert bzw. gut darauf strukturiert abgeschieden werden, sodass sich daraus die Lücke oder die Sollbruchstelle über der jeweiligen Kavität ergibt.

Das Opfermaterial ist im Vergleich zu dem Material des Substrates selektiv ätz- oder lösbar, sodass es ohne Beeinträchtigung des Substratmaterials aus diesem entfernt werden kann. Nach einer solchen zumindest teilweisen Entfernung des Opfermaterials hat der Teil des Auslegers, der über die Kavität ragt, keinen physischen Kontakt mehr zum Opfermaterial und kann daher relaxieren, wodurch eine gezielte Verbiegung der Auslegerenden des Auslegers und der darauf befindlichen Nanostruktur erzeugt werden kann, wodurch also gezielt eine bestimmt mechanische Verspannung in die Nanostruktur eingebracht werden kann. Ferner können durch die Entfernung des Opfermaterials freigelegte Auslegerenden derart behandelt werden, dass sich in ihnen eine bestimmte Spannung aufbaut, mit Hilfe der die auf dem jeweiligen Auslegerende befindliche Nanostruktur gespannt werden kann.

Ist zwischen zwei sich jeweils teilweise über die Kavität erstreckenden Auslegern bereits eine Lücke über der Kavität vorhanden, kann sich - je nach vorhandener Vorspannung des jeweiligen Auslegers - ein neben der Lücke befindliches Auslegerende des Auslegers nach einer solchen, wenigstens teilweisen Entfernung des Opfermaterials in das freigelegte Innere der Kavität hineinwölben oder von der Kavität wegwölben oder auch gerade stehen bleiben.

Weist ein sich über die Kavität erstreckender Auslegern zunächst nur eine Sollbruchstelle über der Kavität auf, kann die Sollbruchstelle beispielsweise mittels Ultraschall oder durch eine mechanische Einwirkung durchbrochen werden, wodurch sich beidseitig der durchbrochenen Sollbruchstelle freie Auslegerenden ergeben, von welchen sich - je nach vorhandener Vorspannung des jeweiligen Auslegers - wenigstens eines nach der zumindest teilweisen Entfernung des Opfermaterials in das freigelegte Innere der Kavität hineinwölben oder von der Kavität wegwölben kann oder gerade über der Kavität stehen bleiben kann. Die Sollbruchstelle ist eine vorstrukturierte Trenn- oder Aufrissstelle. Sie bildet ein nachträglich entfernbares oder öffenbares Halteelement aus, dessen Entfernung oder Öffnung es möglich macht, einen ursprünglich in den jeweiligen Ausleger eingebrachten Verspannzustand zu entlassen und dadurch die Nanostruktur zu spannen.

Die Sollbruchstelle kann durch äußere mechanische und/oder thermische und/oder subtraktive Stimulation durchtrennt werden.

Da sich die jeweilige Nanostruktur auf dem wenigstens einen Ausleger befindet, wölbt sich diese mit dem jeweiligen Auslegerende, d. h. entweder in die Kavität hinein oder von der Kavität weg, oder bleibt gerade über der Kavität stehen.

Dabei wird die wenigstens eine Nanostruktur beidseitig der Kavität jeweils durch eine der Kontaktelektroden festgehalten.

In einer bevorzugten Ausführungsform der erfindungsgemäßen Zwischenstruktur steht der wenigstens eine Ausleger unter mechanischer Zugspannung. Bei dieser Ausführungsform der Erfindung wölbt sich nach der zumindest teilweisen Entfernung des Opfermaterials wenigstens eines der dadurch freigelegten Auslegerenden und damit auch die darauf befindliche Nanostruktur in die Kavität hinein.

Durch die mechanische Vor- oder -aufspannung des wenigstens einen Auslegers lassen sich in einer aus dem Zwischenprodukt hergestellten nanoelektronischen Bauelementstruktur sowohl deren elektronische Materialeigenschaften, wie die Ladungsträgermobilität, als auch deren Bauelementeigenschaften, wie Güte und Resonanzfrequenz, verbessern und sogar kontrollieren.

Obwohl bei der vorliegenden Erfindung keine Ausnahmen hinsichtlich der Verwendbarkeit von Nanomaterialien für die wenigstens eine Nanostruktur bestehen, eignen sich für die Ausbildung der wenigstens einen Nanostruktur Graphen und/oder wenigstens eine Kohlenstoffnanoröhre besonders gut. Diese Nanomaterialien lassen sich gut in bestehende Fertigungstechnologien integrieren.

Es hat sich als vorteilhaft erwiesen, wenn als Opfermaterial Kupfer, Wolfram, Siliziumdioxid und/oder Aluminiumoxid verwendet wird, da diese Materialien gut abscheidbar sind und die erforderliche Ätzselektivität zu Silizium als Substratmaterial besitzen. Grundsätzlich sind jedoch auch andere Opfermaterialien einsetzbar. Das jeweilige Opfermaterial sollte selektiv zum verwendeten Substratmaterial aus der jeweiligen Kavität entfernbar sein. So kann das Opfermaterial sowohl anorganisch als auch organisch sein. Zudem kann das Opfermaterial mit subtraktiven Verfahren entweder trocken oder nass entfernbar sein.

In einer vorteilhaften Ausführungsform des erfindungsgemäßen Zwischenproduktes ist in wenigstens einer der wenigstens einen Kavität wenigstens eine Steuerelektrode angeordnet oder ausgebildet. Die jeweilige Steuerelektrode besteht aus mindestens einem elektrisch leitfähigen Material. Die jeweilige Steuerelektrode befindet sich bei dem Zwischenprodukt typischerweise am Boden der Kavität, unter dem Opfermaterial und kann somit durch Entfernung des Opfermaterials freigelegt werden. Mit der Steuerelektrode kann, ähnlich einer Gateelektrode bei MOSFET-Strukturen, eine Ladungsträgerbeeinflussung in der Nanostruktur vorgenommen werden. Bei der vorliegenden Erfindung ist struktur- und verfahrensbedingt die Abstandseinstellung zwischen der Steuerelektrode und der jeweiligen Nanostruktur über die Dicke des Opfermaterials und/oder des jeweiligen Auslegers selbstlimitierend einstellbar. Zudem können bei dieser Ausführungsform der Erfindung die Tiefe der Kavität und die Dicke sowie die jeweils die Kavität am Kavitätsrand überstehende Länge des jeweiligen Auslegers so gewählt werden, dass das Auslegerende nach Entfernung des Opfermaterials auf der Steuerelektrode aufsitzt, es also zu einem "Gate-Touchdown" des Auslegers auf der Steuerelektrode kommt.

Die Aufgabe wird ferner erfindungsgemäß durch eine nanoelektronische Bauelementstruktur gelöst, die ein Substrat, wenigstens eine in dem Substrat ausgebildete Kavität und wenigstens eine die jeweilige Kavität zumindest teilweise überspannende Nanostruktur aufweist, wobei die nanoelektronische Bauelementstruktur wenigstens einseitig der jeweiligen Kavität wenigstens einen die wenigstens eine Kavität nur teilweise überspannenden Ausleger aufweist, so dass über der wenigstens einen Kavität eine Lücke ausgebildet ist, wobei die wenigstens eine Nanostruktur auf dem wenigstens einen Ausleger, jeweils die Lücke überspannend angeordnet ist und zwischen dem wenigstens einen Ausleger und jeweils beidseitig der Lücke ausgebildeten Kontaktelektroden fixiert ist, und wobei der wenigstens eine Ausleger an seinem über oder in die jeweilige Kavität ragenden Auslegerende gebogen oder geschrumpft ist, so dass die wenigstens eine Nanostruktur auf Zug gespannt ist.

Die erfindungsgemäße nanoelektronische Bauelementstruktur kann aus einer Ausführungsform des oben beschriebenen Zwischenproduktes ausgebildet werden.

Im Gegensatz zu dem oben beschriebenen Zwischenprodukt ist bei der erfindungsgemäßen nanoelektronischen Bauelementstruktur kein Opfermaterial oder nur so wenig Opfermaterial in der Kavität, dass der wenigstens eine Ausleger oberhalb der Kavität freigelegt ist.

Bei der erfindungsgemäßen nanoelektronischen Bauelementstruktur ist der wenigstens eine Ausleger entweder durch die zumindest teilweise Entfernung des stützenden Opfermaterials aus der jeweiligen Kavität relaxiert und dadurch vertikal gebogen und/oder durch Schrumpfen horizontal kontrahiert. Bedingt durch die Relaxation der intrinsischen Spannungszustände und/oder die gezielte Spannungseinbringung durch das Schrumpfen ist bei der erfindungsgemäßen nanoelektronischen Bauelementstruktur die laterale Projektion des jeweiligen Auslegers im Vergleich zu dessen lateraler Ausdehnung im Zwischenprodukt verkürzt. Da darüber hinaus bei der erfindungsgemäßen nanoelektronischen Bauelementstruktur die wenigstens eine Nanostruktur auf dem wenigstens einen Ausleger jeweils die Lücke überspannend angeordnet und zwischen dem wenigstens einen Ausleger und den jeweils beidseitig der Lücke ausgebildeten Kontaktelektroden fixiert ist, wird die Nanostruktur gespannt. Die Nanostruktur ist somit bei der erfindungsgemäßen nanoelektronischen Bauelementstruktur in Strecklage versetzt.

Bei der erfindungsgemäßen nanoelektronischen Bauelementstruktur hat die wenigstens eine Nanostruktur eine durch die Wölbung und/oder Schrumpfung wenigstens eines Auslegerendes eingestellte mechanische Verspannung.

Wenn sich wenigstens ein Auslegerende in die Kavität hineinwölbt, ist die wenigstens eine Nanostruktur, die auf dem wenigstens einen Ausleger angeordnet ist und sich somit mit in die Kavität hineinwölbt, auf Zug gespannt. Dann ist also die wenigstens eine Nanostruktur zwischen den Kontaktelektroden mechanisch auf Zug gespannt.

Gleiches gilt, wenn sich wenigstens ein Auslegerende so wölbt, dass es sich von der Kavität wegwölbt du sich dadurch auch die auf dem wenigstens einen Ausleger befindliche Nanostruktur von der Kavität wegwölbt.

Ist wenigstens ein Auslegerende geschrumpft, ist die wenigstens eine auf dem jeweiligen Auslegerende liegende, mittels jeweils einer Elektrode dort festgehaltene und sich über die Kavität erstreckende Nanostruktur gestreckt, also auf Zug gespannt.

Das heißt, bei jeglicher, durch Entspannung oder Schrumpfung hervorgerufenen Verbiegung oder Verformung des wenigstens einen Auslegers ändert sich auch dessen laterale Projektion, sodass sich Fixpunkte zwischen dem Ausleger und der darauf befindlichen Nanostruktur voneinander weg bewegen, wodurch eine Zugspannung in die Nanostruktur eingebracht wird.

Indem sich bei der erfindungsgemäßen nanoelektronischen Bauelementstruktur die wenigstens eine Nanostruktur über die jeweilige Kavität erstreckt, ist die jeweilige Nanostruktur im funktionell aktiven Bereich vom Substrat entkoppelt, wodurch die Eigenschaften der Nanostruktur frei von parasitären Einflüssen des Substrats gehalten werden können. Die erfindungsgemäße nanoelektronische Bauelementstruktur weist somit wenigstens eine vorgespannte, vom Substrat entkoppelte Nanostruktur auf.

Die Entkopplung vom Substrat ist zum Beispiel dann, wenn die erfindungsgemäße nanoelektronische Bauelementstruktur als Nanoresonator genutzt wird oder wenigstens einen Nanoresonator aufweist, wichtig, um parasitäre Wechselwirkungen mit dem Substrat zu unterdrücken.

Die erfindungsgemäße nanoelektronische Bauelementstruktur kann beispielsweise auch ein piezoresistiver Nanomaterial-Dehnungssensor sein, der durch die Vorspannung der wenigstens einen Nanostruktur befähigt ist, erstmals Druckspannung zu detektieren.

Die erfindungsgemäße nanoelektronische Bauelementstruktur besitzt den Vorteil, dass sie mittels gängiger Oberflächentechnologien skalierbar und reproduzierbar hergestellt werden kann.

Weiterhin ist die erfindungsgemäße nanoelektronische Bauelementstruktur äußerst energieeffizient, da keine Peripherie benötigt wird, welche die wenigstens eine Nanostruktur aktiv vorspannt und Energie verbraucht. Die an der wenigstens einen Nanostruktur eingestellte bzw. einstellbare Vorspannung ist dauerhaft.

In bevorzugten Ausführungsformen der erfindungsgemäßen nanoelektronischen Bauelementstruktur ist die wenigstens eine Nanostruktur zwischen den Kontaktelektroden auf Zug gespannt.

Vorzugsweise ist bei einer Ausführungsform der erfindungsgemäßen nanoelektronischen Bauelementstruktur eine von dem Substrat weggewandte Seite der wenigstens einen Nanostruktur stärker gespannt als eine zu dem Substrat hingewandte Seite der wenigstens einen Nanostruktur. Um dies zu erreichen, kann beispielsweise eine von dem Substrat wegzeigende Seite des Auslegers, auf dem die jeweilige Nanostruktur angeordnet ist, stärker als eine an das Substrat angrenzende Seite dieses Auslegers geschrumpft sein.

Um beispielsweise einen Stromfluss in der wenigstens einen Nanostruktur steuern zu können, ist es von Vorteil, wenn in wenigstens einer der wenigstens einen Kavität wenigstens eine Steuerelektrode angeordnet ist. Vorzugsweise ist eine solche Steuerelektrode am Boden der jeweiligen Kavität angeordnet.

In einer vorteilhaften Weiterbildung der Erfindung weist das Substrat eine Mehrzahl der Kavitäten auf, die jeweils von wenigstens einer der Nanostrukturen überspannt sind, wobei wenigstens zwei der Kavitäten unterschiedliche Breiten und/oder Tiefen und/oder Längen aufweisen und/oder wenigstens zwei der Nanostrukturen unterschiedliche Breiten und/oder Längen aufweisen und/oder wenigstens zwei der Nanostrukturen in unterschiedliche Raumrichtungen ausgerichtet und/oder mechanisch gespannt sind. So können die jeweiligen Nanostrukturen mit unterschiedlicher Spannungshöhe und/oder Spannungsausrichtung ausgebildet werden, wodurch sie für unterschiedliche Messbereiche und/oder für die Erfassung unterschiedlicher Kraft- oder Spannungsvektoren ausgelegt werden können. Ferner können auf diese Weise durch die jeweiligen Nanostrukturen etwaige Messfehler ausgeglichen und/oder Messsignale verstärkt werden, da beispielsweise bei piezoresistiven Halbbrückenschaltungen sowohl Sensor- als auch Ausgleichselemente innerhalb einer Zone homogener Eigenschaften, d. h. innerhalb der Domänengrenze, der jeweiligen Nanostruktur realisiert werden können.

In favorisierten Ausführungsformen der erfindungsgemäßen nanoelektronischen Bauelementstruktur weist die wenigstens eine Nanostruktur Graphen und/oder wenigstens eine Kohlenstoffnanoröhre auf. Es kommen jedoch für die Ausbildung der wenigstens einen Nanostruktur auch andere Nanomaterialien, wie zum Beispiel Nanodrähte mit einem Durchmesser in einem Bereich bis maximal 100 nm aus anderen Metallen, Nichtmetallen oder Halbleitern, in Betracht.

In einer günstigen Ausführungsform der Erfindung befindet sich wenigstens in der wenigstens einen Kavität ein geschrumpftes Füllmaterial, auf dem wenigstens ein Auslegerende aufliegt oder in das wenigstens ein Auslegerende eingebunden ist. So kann bei der erfindungsgemäßen nanoelektronischen Bauelementstruktur wenigstens einer der Ausleger bedingt durch den Wegfall der vorherigen Auslegerfixierung infolge Opfermaterialentfernung und durch Auflage oder Einbindung des jeweiligen Auflegers auf bzw. in das geschrumpfte Füllmaterial in einen neuen, dauerhaft definierten Spannungszustand verbracht sein oder werden.

Das Füllmaterial kann ein Material sein, das neben der Schrumpfungseigenschaft auch noch andere Zwecke, wie eine Passivierung wenigstens eines Teils der nanoelektronischen Bauelementstruktur und/oder eine Fixierung wenigstens eines Elementes der nanoelektronischen Bauelementstruktur, erfüllt. Mit der Passivierung kann beispielsweise eine hermetische Abschirmung des Nanomaterials der jeweiligen Nanostruktur erreicht werden.

Umgekehrt kann dann, wenn die Zugbeanspruchung der jeweiligen Nanostruktur einzig und allein durch die Relaxation verspannter Auslegerenden erfolgt, ein Passivierungsmaterial verwendet werden, das keine Schrumpfeigenschaften besitzt.

Alternativ kann man mit einer schrumpfenden Passivierung eine Nanostruktur verspannen, die sich beispielsweise auf nur aus einer einzigen Schicht ausgebildeten Auslegern, die vorher gar nicht verspannt sind, befindet.

Eine Biegung des wenigstens einen Auslegers und damit die Verspannung der wenigstens einen Nanostruktur kann man dauerhaft aufrecht erhalten, wenn wenigstens ein in die wenigstens eine Kavität ragendes Auslegerende des jeweiligen Auslegers durch ein in die jeweilige Kavität eingebrachtes Füllmaterial fixiert ist.

Es ist auch möglich, die wenigstens eine Nanostruktur selbst mit dem Füllmaterial zu überdecken, um deren Spannungszustand zu erhalten.

Das Füllmaterial ist vorzugsweise ein Material, das neben der Fixiereigenschaft auch noch andere Zwecke, wie eine Passivierung wenigstens eines Teils der nanoelektronischen Bauelementstruktur, erfüllt und/oder schrumpfbar ist.

Es kann somit bei der vorliegenden Erfindung zur Spannungseinstellung der jeweiligen Nanostruktur mittels Schrumpfung des Füllmaterials und/oder zur Fixierung wenigstens eines freigelegten Auslegers und/oder von Nanostrukturen und/oder zur Passivierung ein und dasselbe Füllmaterial eingesetzt werden.

Wenn an der wenigstens einen Nanostruktur jeweils wenigstens ein Massekörper angeordnet ist, können Auslenkungen der wenigstens einen Nanostruktur verstärkt und/oder die Resonanzfrequenz der jeweiligen Nanostruktur eingestellt und somit eine frequenzabhängige Verstärkung und/oder Filterung von Signalen erreicht werden. Der Massekörper kann beispielsweise aus einem exponierten und/oder freigelegten Teil des jeweiligen Auslegers, auf dem die Nanostruktur aufliegt, ausgebildet sein. Beispielsweise kann der Teil des Auslegers durch Herauslösen des Opfermaterials aus der Kavität zur seismischen Masse geworden sein, die von der Nanostruktur gehalten wird.

Mit oder auf Basis wenigstens einer erfindungsgemäßen nanoelektronischen Bauelementstruktur lassen sich beispielsweise miniaturisierte sensortypische Kompensationsschaltungen, wie Brücken- oder Halbbrückenschaltungen, ausbilden. So können solche Schaltungen innerhalb der Domänengröße der jeweils verwendeten Nanostruktur realisiert werden. Dies führt zu reproduzierbaren und homogenen Bauelementeigenschaften über viele parallel gefertigte Bauelemente. Durch die Brücken- oder Halbbrückenschaltung ist es möglich, selbstkalibrierende Bauteile mit höchstem Signal-zu-RauschVerhältnis und/oder integrierter Driftkorrektur auszubilden.

Die Aufgabe wird darüber hinaus erfindungsgemäß durch ein Verfahren zum Herstellen einer nanoelektronischen Bauelementstruktur gelöst, bei dem in ein Substrat wenigstens eine Kavität eingebracht wird und die jeweilige Kavität mit wenigstens einer Nanostruktur überbrückt wird, wobei die wenigstens eine Kavität wenigstens teilweise mit einem Opfermaterial gefüllt wird, auf der wenigstens teilweise mit dem Opfermaterial gefüllten Kavität entweder wenigstens einseitig der jeweiligen Kavität wenigstens ein die wenigstens eine Kavität nur teilweise überspannender Ausleger ausgebildet wird, so dass über der wenigstens einen Kavität eine Lücke ausgebildet ist, oder wenigstens ein die jeweilige Kavität überspannender Ausleger mit einer Sollbruchstelle über der wenigstens einen Kavität ausgebildet wird, die wenigstens eine Nanostruktur auf dem wenigstens einen Ausleger, die jeweilige Lücke oder Sollbruchstelle überspannend ausgebildet oder angeordnet wird, auf beidseitig der jeweiligen Kavität ausgebildeten Nanostrukturenden der jeweiligen Nanostruktur jeweils eine Kontaktelektrode ausgebildet wird, nachfolgend das Opfermaterial aus der jeweiligen Kavität zumindest teilweise herausgeätzt oder herausgelöst wird und, falls vorhanden, die Sollbruchstelle durchbrochen wird.

Mit dem erfindungsgemäßen Verfahren können nanoelektronischen Bauelementstrukturen mit lokal kontrollierbaren bzw. lokal gezielt einstellbaren mechanischen Spannungszuständen hergestellt werden. Es können insbesondere definierte Spannungszustände ortsindividuell und anpassbar in einzelnen oder Gruppen von 1D- oder 2D-Nanostrukturen eingebracht werden.

Dabei kann die Verspannung der wenigstens einen Nanostruktur im Sub-MikrometerBereich eingestellt werden, was auch die Schaffung von Arrays mit variablen Einzelbauelementeigenschaften auf kleinstem Raum ermöglicht. Dies wird beispielsweise als Grundvoraussetzung für bildgebende breitbandige Sensoren für mechanischen Stress, atomare/chemische Spezies der Umgebung sowie für optische Strahlung angesehen.

Die Verfahrensschritte des erfindungsgemäßen Verfahrens sind kompatibel zu bestehenden monolithischen Integrationstechnologien. Das erfindungsgemäße Verfahren lässt sich somit ohne Weiteres in bestehende Fertigungsabläufe oder in eine Hetero-Systemintegration integrieren. Das erfindungsgemäße Verfahren ist auch mit Beyond-CMOS- und in System-on-Chip-Technologien kompatibel. Damit können neuartige hybride Bauteile mit verknüpfter Funktionalität aus Sensorik, Aktorik und Elektronik geschaffen werden.

Für das erfindungsgemäße Verfahren sind keine hohen Temperaturen notwendig. Somit ist Prozesskompatibilität gegeben.

Bei dem erfindungsgemäßen Verfahren kann durch selbstlimitierende Abscheidungen des zur Ausbildung der wenigstens einen Nanostruktur verwendeten Nanomaterials eine besonders hohe Reproduzierbarkeit der Bauelementfertigung erreicht werden.

Es ist aber auch möglich, die wenigstens eine Nanostruktur unabhängig vom Fertigungsprozess des Substrates zu erzeugen und schlussendlich auf dieses zu übertragen. Eine solche Vorgehensweise besitzt den Vorteil der Ausmerzung von Inkompatibilitäten in der Fertigungslinie, welche die Nutzung von klassischen Prozessen mit sich bringt. Mittels dieses Transferansatzes besteht zusätzlich die Möglichkeit, direkt während des Übertrags der wenigstens einen Nanostruktur auf das Substrat weitere mechanische Vorspannung in das Nanomaterial der jeweiligen Nanostruktur einzubringen.

Bei dieser Vorgehensweise wird die wenigstens eine vorzugsweise vorher geordnete und ausgerichtete Nanostruktur auf dem zuvor prozessierten Substrat positioniert. Es folgt die elektrische Kontaktierung der wenigstens einen Nanostruktur durch eine auf sie angepasste Lithografie-Technologie und die Freistellung des wenigstens einen Auslegers mit der darauf befindlichen wenigstens einen Nanostruktur, wodurch sich eine vordefinierte Verspannung in der wenigstens einen Nanostruktur einstellt.

Das erfindungsgemäße Verfahren erlaubt die Herstellung selbst-referenzierender bzw. selbst-kalibrierender Schaltungen mit nanoelektronischen Bauelementstrukturen, die innerhalb einer Domäne des jeweiligen Nanomaterials geschaffen werden, welche auch die inhärente Drift in den Bauteileigenschaften kompensiert.

In bevorzugten Ausführungsformen des erfindungsgemäßen Verfahrens wird wenigstens einer der Ausleger aus wenigstens zwei Lagen aus solchen Materialien, unter Verwendung solcher Prozessparameter und mit solchen Lagendicken ausgebildet, dass er direkt nach den Lagenabscheideschritten unter mechanischer Zugspannung steht, also eine residuelle Schichtspannung aufweist. In diesen Ausführungsformen ist der jeweilige Ausleger beispielsweise als verspannte Doppelschicht ausgebildet, die sich nach der zumindest teilweisen Entfernung des Opfermaterials aus der Kavität entspannt.

Es kann jedoch auch in den jeweiligen Ausleger erst nach dessen Abscheidung eine Spannung eingebracht werden, beispielsweise indem Auslegerenden des jeweiligen Auslegers nach dessen Freilegung durch die Opfermaterialentfernung mittels Tempern geschrumpft werden.

Erweiterte Funktionalität bietet die Anordnung wenigstens einer Steuerelektrode im Umfeld der wenigstens einen Nanostruktur. Eine oder mehrere solche(r) Steuerelektrode(n) kann/können beispielsweise in einer Ausführungsform des erfindungsgemäßen Verfahrens in wenigstens einer der wenigstens einen Kavität, bevor diese mit dem Opfermaterial zumindest teilweise gefüllt wird, angeordnet oder ausgebildet werden. Die jeweilige Steuerelektrode kann vorzugsweise am Boden der jeweiligen Kavität ausgebildet werden. Da das in dem erfindungsgemäße Verfahren verwendete Herauslösen oder Herausätzen des Opfermaterials aus der wenigstens einen Kavität ein selbstjustierender Prozess ist, kann damit nicht nur entwurfsbestimmt die Vorspannung eingestellt werden, sondern dabei auch adäquate Bauteileigenschaften, wie den Abstand von der Steuerelektrode zu der wenigstens einen Nanostruktur und damit der Arbeitspunkt der ausgebildeten nanoelektronischen Bauelementstruktur, beeinflusst werden.

Ein unterschiedliche Nanostrukturen aufweisendes und damit unterschiedliche Mess- oder Funktionsbereiche abdeckendes Array oder Modul kann mit Hilfe des erfindungsgemäßen Verfahrens ausgebildet werden, wenn bei diesem wenigstens zwei der Kavitäten jeweils mit unterschiedlichen Breiten und/oder Tiefen und/oder Längen ausgebildet werden und/oder wenigstens zwei der Nanostrukturen in jeweils unterschiedliche Raumrichtungen ausgerichtet ausgebildet werden und/oder in jeweils unterschiedliche Raumrichtungen mechanisch gespannt werden. Mit dieser Technologie können in verschiedene Raumrichtungen orientierte Nanostrukturen, also multidirektionale Nanostrukturen, parallel gefertigt werden. Durch die jeweiligen Geometrien und/oder Ausrichtungen der Nanostrukturen können diese genau skaliert werden.

Hierdurch ist es möglich, hinsichtlich ihrer Eigenschaften selektierte Nanostrukturen mit steuerbarer Anordnung in das Array oder das Modul zu integrieren.

Durch Nutzung von selbstanordnenden Effekten kann zudem eine parallele Ausrichtung der Nanostrukturen über das Substrat erreicht werden.

Nanoelektronische Bauelementstrukturen mit guter Reproduzierbarkeit können mit dem erfindungsgemäßen Verfahren hergestellt werden, wenn als Material(ien) für die Ausbildung der wenigstens einen Nanostruktur Graphen und/oder wenigstens einer Kohlenstoffnanoröhre verwendet wird.

Der jeweilige Ausleger kann auch dadurch definiert verspannt werden, dass nach dem zumindest teilweisen Herausätzen oder Herauslösen des Opfermaterials aus der wenigstens einen Kavität in die jeweilige Kavität wenigstens ein Füllmaterial eingebracht und dieses nachfolgend durch Tempern und/oder Aushärten geschrumpft wird.

Nach Relaxation der Auslegers durch das zumindest teilweise Entfernen des Opfermaterials aus der jeweiligen Kavität können in einer vorteilhaften Ausführungsform des erfindungsgemäßen Verfahrens in die wenigstens eine Kavität ragende Auslegerenden durch Einbringen eines Füllmaterials in die jeweilige Kavität fixiert werden.

Dabei kann das Füllmaterial auch auf die wenigstens eine Nanostruktur aufgebracht werden, um deren Fixierung und somit ein Erhalten der darin eingebrachten Spannung zu erreichen.

Obwohl bei der vorliegenden Erfindung grundsätzlich unterschiedlichste Füllmaterialien zum Einsatz kommen können, hat es sich zum Erreichen guter Schrumpfungseigenschaften als vorteilhaft erwiesen, wenn das wenigstens eine Füllmaterial wenigstens ein Silsesquioxan, wie zum Beispiel Wasserstoffsilsesquioxan, und/oder wenigstens ein sich vernetzendes Polymer aufweist.

Eine besonders gute Auslenkbarkeit der wenigstens einen Nanostruktur kann erreicht werden, wenn in einer Ausführungsform des erfindungsgemäßen Verfahrens an der wenigstens einen Nanostruktur jeweils wenigstens ein Massekörper ausgebildet wird. Dabei kann der wenigstens eine Massekörper in der vorliegenden Erfindung beispielsweise als träge Masse für einen Inertialsensor und/oder mechanischen Resonator oder als Element eines Plattenkondensators zur Realisierung einer MEMS/NEMS-Aktorik fungieren.

In einer bevorzugten Ausführungsform des erfindungsgemäßen Verfahrens wird der wenigstens eine Massekörper aus dem wenigstens einen Ausleger während des zumindest teilweisen Herausätzens oder Herauslösens des Opfermaterials aus der wenigstens einen Kavität ausgebildet.

Die Verspannung der wenigstens einen Nanostruktur lässt sich besonders gut kontrollieren, wenn die wenigstens eine Nanostruktur mittels eines gedehnten Transferträgers auf den wenigstens einen Ausleger aufgebracht wird. Mit dem gedehnten Transferträger lässt sich beispielsweise auf dem ganzen Substrat eine vorgespannte Nanomaterialschicht aufbringen, aus der dann durch entsprechende geometrische Gestaltung der wenigstens einen darunter befindlichen Kavität und des wenigstens einen sich über die jeweilige Kavität erstreckenden Auslegers wenigstens eine Nanostruktur mit einer kontrollierten Spannung und Spannungsrichtung im Sub-Mikrometerbereich ausgebildet werden kann.

Bevorzugte Ausführungsformen der vorliegenden Erfindung, deren Aufbau, Funktion und Vorteile werden im Folgenden anhand von Figuren näher erläutert, wobei
- Figur 1: schematisch eine Ausführungsform einer erfindungsgemäßen nanoelektronischen Bauelementstruktur in einer geschnittenen Seitenansicht zeigt;
- Figur 2: schematisch eine weitere Ausführungsform einer erfindungsgemäßen nanoelektronischen Bauelementstruktur in einer geschnittenen Seitenansicht zeigt;
- Figur 3: schematisch noch eine weitere Ausführungsform einer erfindungsgemäßen nanoelektronischen Bauelementstruktur in einer geschnittenen Seitenansicht zeigt;
- die Figuren 4 bis 12: schematisch Verfahrensschritte einer Ausführungsform des erfindungsgemäßen Verfahrens zur Herstellung der nanoelektronischen Bauelementstruktur aus Figur 1 jeweils in einer geschnittenen Seitenansicht durch die jeweils ausgebildete Struktur zeigen;
- Figur 13: die nanoelektronische Bauelementstruktur aus Figur 12 mit ein-und aufgebrachtem Füllmaterial zeigt;
- die Figuren 14 bis 17: schematisch Verfahrensschritte einer weiteren Ausführungsform des erfindungsgemäßen Verfahrens zur Herstellung einer nanoelektronischen Bauelementstruktur jeweils in einer geschnittenen Seitenansicht durch die jeweils ausgebildete Struktur zeigen;
- Figur 18: schematisch die Einstellbarkeit der Verspannung sowie der elektrostatischen Kopplung zur jeweiligen Steuerelektrode an erfindungsgemäßen nanoelektronischen Bauelementstrukturen demonstriert;
- Figur 19: schematisch eine erfindungsgemäße nanoelektronische Bauelementstruktur in Form eines CNT-FET-Arrays mit individueller Verspannung der jeweiligen Nanostrukturen zeigt;
- Figur 20: schematisch eine weitere erfindungsgemäße nanoelektronische Bauelementstruktur mit einer heterogen verzerrten Graphen-Schicht zeigt;
- Figur 21: schematisch noch eine weitere erfindungsgemäße nanoelektronische Bauelementstruktur in Form eines Arrays mit variablen Spannungszuständen innerhalb einer Nanomaterialdomäne zeigt, und
- Figur 22: schematisch eine erfindungsgemäße nanoelektronische Bauelementstruktur in Form einer innerhalb einer Nanomaterialdomäne ausgebildeten Sensorhalbbrücke zeigt.

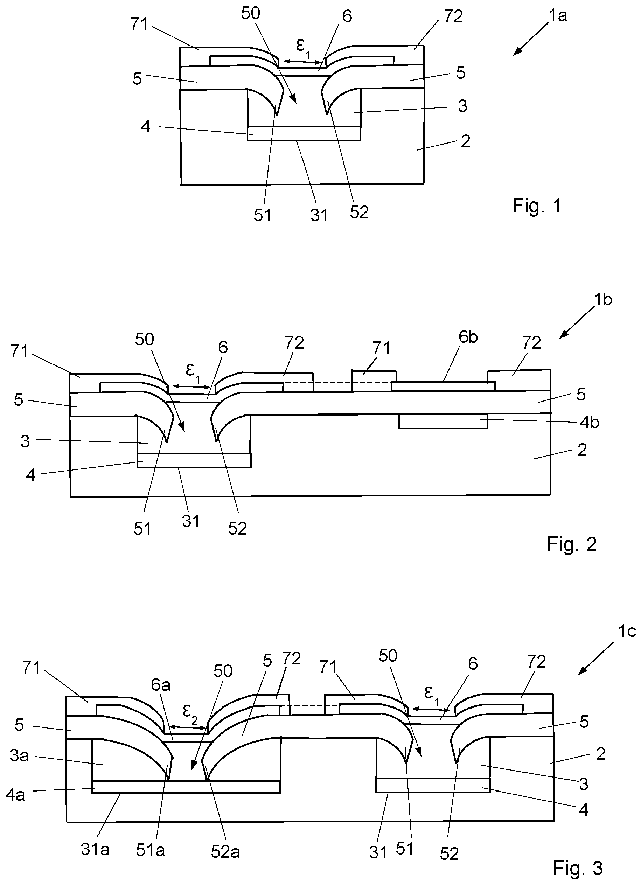

Die Figuren 1 bis 3 zeigen schematisch mögliche Ausführungsformen von erfindungsgemäßen nanoelektronischen Bauelementstrukturen 1a, 1b, 1c jeweils in einer geschnittenen Seitenansicht.

Die nanoelektronische Bauelementstruktur 1a kann als eine Art "Kernzelle" eines mit der vorliegenden Erfindung ausbildbaren vorgespannten Nanomaterialsystems angesehen werden und eignet sich daher gut zur Demonstration der Erfindung. Die nanoelektronische Bauelementstruktur 1a weist ein Substrat 2, eine darin ausgebildete Kavität 3, eine an einem Boden 31 der Kavität 3 ausgebildete Steuerelektrode 4, jeweils teilweise die Kavität 3 überlappende Ausleger 5, eine auf beiden freien Auslegerenden 51, 52 der Ausleger 5 aufliegende und beidseitig von einer Kontaktelektrode 71, 72 überdeckte Nanostruktur 6 auf. Dadurch, dass die beiden Ausleger 5 in die Kavität 3 hineinhängen, ist die auf den Auslegerenden 51, 52 liegende Nanostruktur 6 gespannt, wie es durch den Pfeil ε₁ schematisch gezeigt ist.

Die Nanostruktur 6 kann aus einem sich wenige hundert Nanometer bis mehrere Mikrometer erstreckenden 1D- oder 2D-Nanomaterial bestehen. Die Nanostruktur 6 weist gezielt eingestellte Grundeigenschaften, wie Chiralität, Durchmesser und/oder MW/SW, auf. Wie es im Folgenden noch näher erläutert wird, wurde die Verspannung der Nanostruktur 6 durch Einsatz herkömmlicher oberflächentechnologischer Prozessschritte erzeugt. In der gezeigten Ausführungsform wurde in die Nanostruktur 6 entlang einer räumlichen Achse kontrolliert eine Zugspannung eingebracht.

Die nanoelektronische Bauelementstruktur 1b aus Figur 2 weist ein Substrat 2 auf, in das zwei unterschiedliche Nanomaterialstrukturen eingebracht sind. Eine erste dieser Nanomaterialstrukturen weist wie die nanoelektronische Bauelementstruktur 1a eine in dem Substrat 2 ausgebildete Kavität 3, eine an einem Boden 31 der Kavität 3 ausgebildete Steuerelektrode 4, jeweils teilweise die Kavität 3 überlappende Ausleger 5 und eine auf beiden freien Auslegerenden 51, 52 der Ausleger 5 aufliegende und beidseitig von einer Kontaktelektrode 71, 72 überdeckte Nanostruktur 6 auf. Eine zweite der Nanomaterialstrukturen ist ohne Kavität, d.h. an der Substratoberfläche, ausgebildet und weist eine Steuerelektrode 4 auf, über der einer der Ausleger 5 verläuft und der gegenüber eine weitere Nanostruktur 6b angeordnet ist, die beidseitig von Kontaktelektroden 71, 72 kontaktiert ist.

Bei dieser Anordnung befinden sich auf dem gleichen Substrat 2 die verspannte Nanostruktur 6 und die als interne Referenz für die Nanostruktur 6 dienende unverspannte Nanostruktur 6b.

Die nanoelektronische Bauelementstruktur 1c aus Figur 3 weist ein Substrat 2 auf, in das ebenfalls zwei unterschiedliche Nanomaterialstrukturen eingebracht sind. Beide dieser Nanomaterialstrukturen weisen wie die nanoelektronische Bauelementstruktur 1a aus Figur 1 eine in dem Substrat 2 ausgebildete Kavität 3, 3a eine an einem Boden 31, 31a der jeweiligen Kavität 3, 3a ausgebildete Steuerelektrode 4, 4a, jeweils teilweise die jeweilige Kavität 3, 3a überlappende Ausleger 5 und jeweils eine auf den jeweiligen freien Auslegerenden 51, 52; 51a, 52a der Ausleger 5 aufliegende und jeweils beidseitig von einer Kontaktelektrode 71, 72 überdeckte Nanostruktur 6, 6a auf. Allerdings sind die Geometrien der Kavitäten 3, 3a und damit auch die Wölbungen der Auslegerenden 51, 52; 51a, 52a in die jeweilige Kavität 3, 3a hinein und damit auch die Verspannungen ε₁, ε₂ der beiden Nanostrukturen 6, 6a unterschiedlich.

Wie es schematisch durch die Strichellinien in den Figuren 2 und 3 angedeutet ist, sind die jeweiligen Nanostrukturen 6, 6b bzw. 6, 6a jeweils aus ein und demselben Nanomaterial ausgebildet. Mit der in Figur 3 schematisch dargestellten nanoelektronischen Bauelementstruktur 1c ist somit eine lokale Kontrolle von verschiedenen Spannungszuständen innerhalb von Domänengrenzen des jeweils für die Nanostrukturen 6, 6a verwendeten 1D- oder 2D-Nanomaterials möglich.

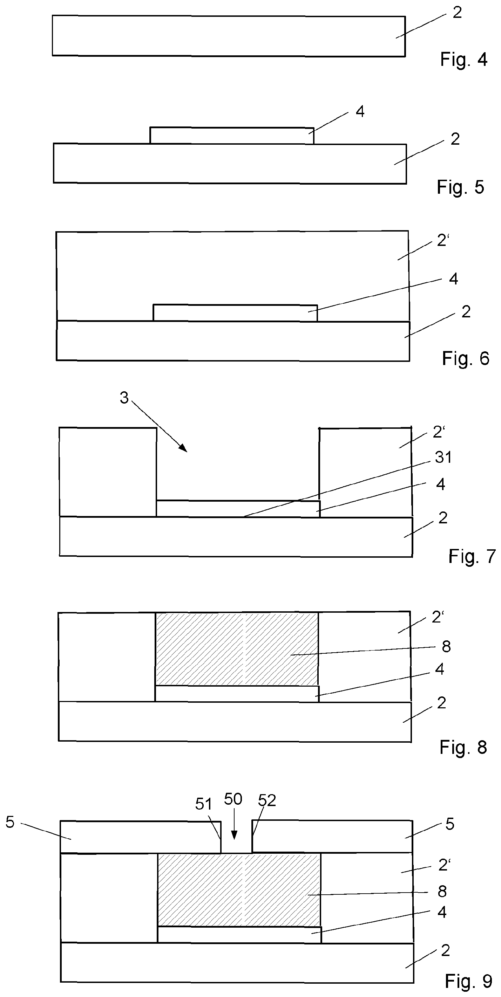

Die Figuren 4 bis 12 zeigen schematisch Verfahrensschritte einer Ausführungsform des erfindungsgemäßen Verfahrens zur Herstellung der nanoelektronischen Bauelementstruktur 1a aus Figur 1.

Wie in Figur 4 zu sehen, wird zunächst ein Substrat 2 bereitgestellt.

In dem in Figur 5 dargestellten Verfahrensschritt wird auf dem Substrat 2 eine Steuerelektrode 4 erzeugt.

Daraufhin wird, wie in Figur 6 gezeigt, eine Spacerschicht 2' abgeschieden, die zwar nicht aus dem gleichen Material wie das Substrat 2 bestehen muss, aber in der vorliegenden Erfindung funktionell dem Substrat 2 zugeordnet wird.

In dem in Figur 7 dargestellten Verfahrensschritt wird in der Spacerschicht 2' eine Kavität 3 ausgebildet. An einem Boden 31 der Kavität 3 befindet sich die Steuerelektrode 4.

Die Kavität 3 wird nachfolgend, wie in Figur 8 gezeigt, mit einem Opfermaterial 8 gefüllt. Das Opfermaterial 8 kann organischen oder anorganischen Ursprungs sein. Vorzugsweise wird das Opfermaterial 8 in Abhängigkeit von der Wahl des Materials und des Verspannungsgrades der im anschließenden Verfahrensschritt erzeugten Ausleger 5 sowie der Kompatibilität zum gesamten Herstellungsprozess ausgewählt.

Danach werden, wie in Figur 9 zu sehen, auf der Spacerschicht 2' und dem Opfermaterial 8 beidseitig und oberhalb der Kavität 3 Ausleger 5 abgeschieden, wobei zwischen Auslegerenden 51, 52 der Ausleger 5, oberhalb der Kavität 3 eine Lücke 50 besteht. In anderen Ausführungsformen der vorliegenden Erfindung kann auch ein einziger Ausleger 5 sich über die Kavität 3 erstreckend ausgebildet sein und anstelle der Lücke 50 eine Sollbruchstelle über der Kavität 3 in diesem Ausleger 5 ausgebildet sein.

Die Ausleger 5 können entweder durch Stapelung von mindestens zwei dünnen Schichten unterschiedlichen Materials erzeugt oder durch eine einzelne dünne Schicht mit einer prozessinduzierten Verspannung innerhalb der Schicht während deren Schichtabscheidung erzeugt werden. Dadurch ist die intrinsische Verspannung des so erzeugten Auslegers 5 exakt einstellbar und vorerst fixiert, da sie an dem darunter liegenden Opfermaterial 8 anhaftet.

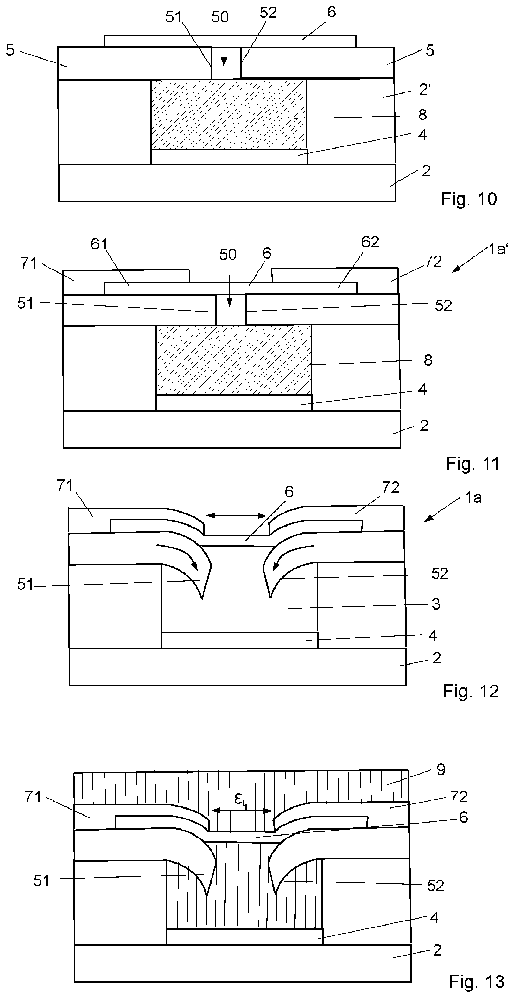

Nachfolgend wird, wie in Figur 10 zu sehen, eine Nanostruktur 6 auf die als Träger dienenden Ausleger 5 aufgebracht. Für das Aufbringen der jeweiligen Nanostruktur 6 können vielfältige Verfahren zum Einsatz kommen. So können selektierte und funktionalisierte Nanomaterialien, wie z. B. Kohlenstoffnanoröhren (CNT), in dispergierter Form mittels Selbstanordnung, Drucken, Dielektrophorese oder Thermophorese etc. als Nanostruktur 6 aufgebracht werden.

Alternativ können Transferprozesse zum Aufbringen der Nanostruktur 6 zum Einsatz kommen, die erweiterte Kontrollmöglichkeiten hinsichtlich der Verspannung der Nanostruktur 6 bieten. Hierfür bedient man sich z. B. CVD-Prozessen (Chemischen Dampfphasenabscheidungs-Prozessen) zur Synthese von beispielsweise CNT, Graphen, MoS₂ oder WS oder auch ALD-Prozessen (Atomlagenabscheidungs-Prozessen) für MoS₂ auf einem Quellsubstrat. Eine polymerbasierte Transfermethode auf Basis von Haftvermittlern und temporären Transferträgern, wie z. B. einer Folie, überträgt die Nanostruktur 6 auf das beispielsweise wie oben vorprozessierte Substrat 2.

In einer besonders vorteilhaften Ausführungsform der vorliegenden Erfindung kann der Transferprozess der Nanostruktur 6 auf einem kontrolliert gedehnten Transferträger vorgenommen werden. Mit dieser Vorgehensweise kann eine flächendeckende Grundverspannung der Nanostrukturen der jeweiligen nanoelektronischen Bauelementstruktur erzielt werden, die zur Homogenisierung, Ausrichtung und Glättung der jeweiligen Nanostrukturen führt.

In einem nächsten, in Figur 11 gezeigten Verfahrensschritt, wird auf beide Nanostrukturenden 61, 62 der Nanostruktur 6 jeweils eine Kontaktelektrode 71, 72 abgeschieden. Im Ergebnis entsteht das in Figur 11 schematisch gezeigte erfindungsgemäße Zwischenprodukt 1a'.

Danach erfolgt, wie in Figur 12 schematisch dargestellt, ein Entfernen des Opfermaterials 8 aus der Kavität 3. Das Entfernen des Opfermaterials 8 kann durch ein geeignetes selektiv-subtraktives Verfahren einer Oberflächentechnologie, wie durch ein Herauslösen oder Herausätzen, erfolgen. Das Opfermaterial 8 kann chemisch und/oder thermisch und/oder mittels Auflösen in Wasser oder einem anderen Lösemittel und/oder durch Ultraschall entfernt werden.

Wie es in Figur 12 schematisch gezeigt ist, kommt es durch das Entfernen des Opfermaterials 8 gleichzeitig zu einer Relaxation der darüber liegenden vorgespannten Ausleger 5. In Abhängigkeit der gewählten Materialien und Depositionscharakteristika erfolgt eine Biegung der Ausleger 5 in die Ebene hinein oder aus der Ebene heraus.

Die gezielt auf zwei gegenüberliegenden Auslegern 5 positionierte und an ihren Nanostrukturenden 61, 62 fixierte Nanostruktur 6 erfährt im Moment der Relaxation der Ausleger 5 in dem gezeigten Ausführungsbeispiel eine Zugkraft, da sich die Fixpunkte der Nanostruktur 6 auf den Auslegerenden 51, 52 voneinander wegbewegen. Im gleichen Moment erfolgt die Freistellung der Nanostruktur 6.

Durch das Herauslösen des Opfermaterials 8 verändert sich auch die Lücke 50 zwischen den Auslegerenden 51, 52. Die Nanostruktur 6 spannt sich über dieser Lücke 50 auf und bildet im Bereich zwischen den Fixpunkten eine freigestellte, ortsindividuell verspannte ein- oder zweidimensionale Struktur aus Nanomaterial. Im Ergebnis des Entfernens des Opfermaterials 8 entsteht somit die gezeigte nanoelektronische Bauelementstruktur 1a.

Die Größe der erzeugten Zugkraft, und damit die Verspannung der Nanostruktur 6, wird definiert durch eine gezielt erzeugte geometrische Gestaltung der Ausleger 5. Die nach Entfernung des Opfermaterials 8 entstandene Überhanglänge, -breite und -höhe der Auslegerenden 51, 52, die gezielt eingebrachte intrinsische Verspannung und die gewählten Materialien für die Ausleger 5 sind die maßgebenden Parameter zur Erzeugung eines gewünschten Biegeradius bzw. einer bestimmten Spannung in der Nanostruktur 6.

Biegeradius und Überhanghöhe sind die bestimmenden Faktoren zur Festlegung der maximalen Auslenkung der Auslegerenden 51, 52 und dienen hiernach zur genaueren Limitierung und Festlegung der Längenänderung der Nanostruktur 6. Weiterhin stellt die Position der Fixierung der Nanostruktur 6 auf dem jeweiligen Ausleger 5 einen wichtigen Faktor dar. Die Genauigkeit, Auflösung und Reproduzierbarkeit ist hierbei limitiert durch das angewendete Strukturierungsverfahren. Typischerweise kommt Elektronenstrahllithografie zur Anwendung, schließt jedoch die Nutzung alternativer Mikro- und Nanostrukturierungsverfahren nicht aus. Diese vorher genannte Fixierung wird in der gezeigten Ausführungsform mittels der Kontaktelektroden 71, 72 realisiert, die gleichzeitig der elektrischen Kontaktierung der Nanostruktur 6 dienen.

Die oben beschriebene Oberflächentechnologie ist nicht begrenzt auf ein bestimmtes Substrat 2 und kann auch in eine Hetero-Systemintegrationstechnologie für beispielsweise System-on-Chip oder Post-Back-end-of-line integriert sein.

Die Einstellung des Verspannungszustands der Ausleger 5 und/oder der Nanostruktur 6 kann durch in der Mikro- und Nanotechnologie etablierte, additive Beschichtungsverfahren erfolgen. Durch Anwendung von Strukturierungsverfahren, wie optischer Lithografie, ist dieser nachträgliche Anpassungsschritt ortsindividuell oder global über das Substrat 2 möglich.

In der gezeigten Ausführungsform berührt die im gestressten Zustand befindliche Nanostruktur 6 nicht den Boden 31 der Kavität 3 und hängt damit frei.

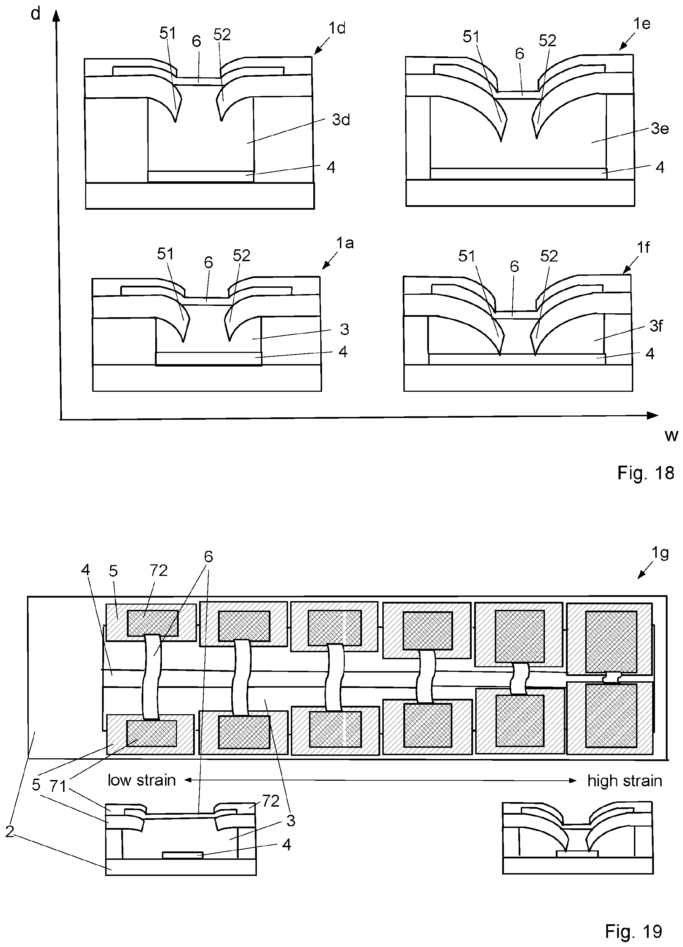

In anderen Ausführungsformen der vorliegenden Erfindung können die jeweils verwendeten Ausleger 5 aus mindestens zwei Schichten bestehen und derart intrinsisch verspannt sein, dass es bei Freilegung zu einer Verbiegung in Richtung des Substrates 2 mit Anschlag führt und bei vergleichsweise hoher Zugkraft der Ausleger 5 die Längenänderung der Nanostruktur 6 durch Tiefe d und Breite w der Kavität 3 bestimmt wird, was auch in Figur 18 zu sehen ist.

Figur 13 zeigt schematisch die nanoelektronische Bauelementstruktur 1a aus Figur 1 bzw. 12, wobei die Kavität 3 als auch der Bereich über der gespannten Nanostruktur 6 mit einem Füllmaterial 9 verfüllt sind. Mit dem Füllmaterial 9 werden die Auslegerenden 51, 52 in ihrer gebogenen Stellung in der Kavität 3 fixiert und die Vorspannung der Nanostruktur 6 "eingefroren".

Wie es aus den beispielhaft gezeigten nanoelektronischen Bauelementstrukturen 1a, 1b 1c hervorgeht, ist es mit der vorliegenden Erfindung möglich, freigestellte, lokal individuell verspannte 1D- oder 2D-Nanomaterialstrukturen durch Kombination von Schichten oder Schichtstapeln mit intrinsischen Schichtspannungen, Opferstrukturen und kontrolliert angeordneten 1D- oder 2D-Nanostrukturen 6, 6a, 6b zu erzeugen.

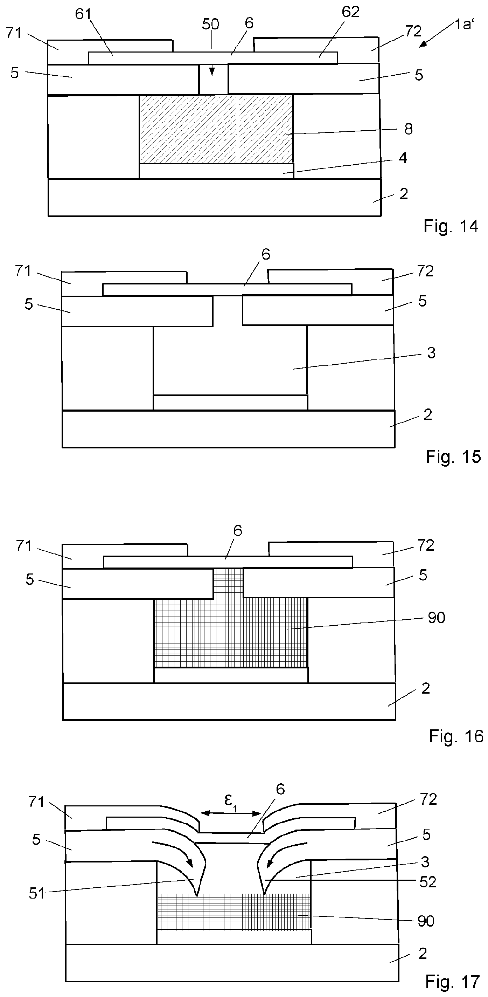

Die Figuren 14 bis 17 zeigen schematisch Verfahrensschritte einer weiteren Ausführungsform des erfindungsgemäßen Verfahrens zur Herstellung einer nanoelektronischen Bauelementstruktur jeweils in einer geschnittenen Seitenansicht durch die jeweils ausgebildete Struktur.

Figur 14 entspricht dem Verfahrensstand aus Figur 11. Die nachfolgend beschriebene weitere Ausführungsform des erfindungsgemäßen Verfahrens beginnt also mit einer Ausführungsform des erfindungsgemäßen Zwischenproduktes 1a'. Die Verfahrensschritte zur Herstellung des Zwischenproduktes 1a' entsprechen den oben im Hinblick auf die Figuren 4 bis 11 beschriebenen Verfahrensschritten.

In dem in Figur 15 gezeigten Verfahrensschritt wird das Opfermaterial 8 aus der Kavität 3 herausgelöst oder herausgeätzt.

Dann wird in dem in Figur 16 gezeigten Verfahrensschritt ein Füllmaterial 90 in die Kavität 3 eingebracht, wobei die Auslegerenden 51, 52 der Ausleger 5 an dem Füllmaterial 90 haften.

In dem Verfahrensschritt von Figur 17 wird die Struktur aus Figur 6 einer erhöhten Temperatur ausgesetzt, bei welcher das Füllmaterial 90 schrumpft. Infolge der Schrumpfung des Füllmaterials 90 in der Kavität 3 biegen sich die Auslegerenden 51, 52 in die Kavität 3 hinein. Die Nanostruktur 6 wird dadurch auf Zug gespannt.

Figur 18 demonstriert schematisch die Einstellbarkeit der Verspannung sowie der elektrostatischen Kopplung zur jeweiligen Steuerelektrode 4 an erfindungsgemäßen nanoelektronischen Bauelementstrukturen 1a, 1d, 1e, 1f. Dabei vergrößert sich in der Pfeilrichtung d die Tiefe der jeweiligen Kavität, während sich in Pfeilrichtung w die Breite der jeweiligen Kavität erhöht. Das heißt, die Kavität 3d ist tiefer als die Kavität 3, die Kavität 3e ist tiefer als die Kavität 3f, die Kavität 3e ist breiter als die Kavität 3d und die Kavität 3f ist breiter als die Kavität 3. Hinsichtlich der weiteren Merkmale der nanoelektronischen Bauelementstrukturen 1a, 1d, 1e, 1f sei auf die obige Beschreibung der nanoelektronischen Bauelementstruktur 1a verwiesen, die auch für die nanoelektronischen Bauelementstrukturen 1d, 1e, 1f gilt.

Wie es an den Abbildungen der Figur 18 erkennbar ist, führt eine breite Kavität mit geringer Tiefe d zu einer verstärkten Verbiegung der jeweiligen Auslegerenden 51, 52 in die jeweilige Kavität hinein. Die Verbiegung der Auslegerenden 51, 52 kann dabei, wie es anhand der nanoelektronischen Bauelementstruktur 1f zu sehen ist, so stark sein, dass diese auf der Steuerelektrode 4 aufliegen, was die Verbiegung und damit die Verspannung der Nanostruktur 6 limitiert.

Figur 19 zeigtschematisch eine in ein einziges Substrat 2 mit einer einzigen Kavität 3 und einer einzigen am Boden der Kavität 3 ausgebildeten Steuerelektrode 4 integrierte erfindungsgemäße nanoelektronische Bauelementstruktur 1g mit einer Mehrzahl von die Kavität 3 überspannenden Nanostrukturen 6. Die nanoelektronische Bauelementstruktur 1g bildet ein CNT-FET-Array mit individueller Verspannung der jeweiligen Nanostrukturen 6. Die jeweils unterschiedliche Verspannung der Nanostrukturen 6 wird hier durch durch die unterschiedlichen Geometrien der Ausleger 5, der Nanostrukturen 6 und der Kontaktelektroden 71, 72 erzielt. Wie es in Figur 19 anhand des Doppelpfeils schematisch gezeigt ist, kann somit die Verspannung in einem Bereich von einer geringen Verspannung (low strain) bis zu einer hohen Verspannung (high strain) der jeweiligen Nanostruktur 6 individuell eingestellt werden.

In anderen Ausführungsformen der vorliegenden Erfindung kann ein ähnliches Array wie in Figur 19 auch mit sich ändernder Geometrie der Kavität 3, wie z. B. sich allmählich verändernder Kavitätentiefe und/oder -breite, ausgebildet werden.

Ferner ist es möglich, an dem Kavitätboden oder über der jeweiligen Passivierung mehrere Steuerelektroden 4 vorzusehen. Die jeweilige Steuerelektrode(n) 4 dient der elektrostatischen Steuerung der jeweiligen Nanostruktur(en) 6 und/oder dem Einstellen wenigstens eines Arbeitspunktes.

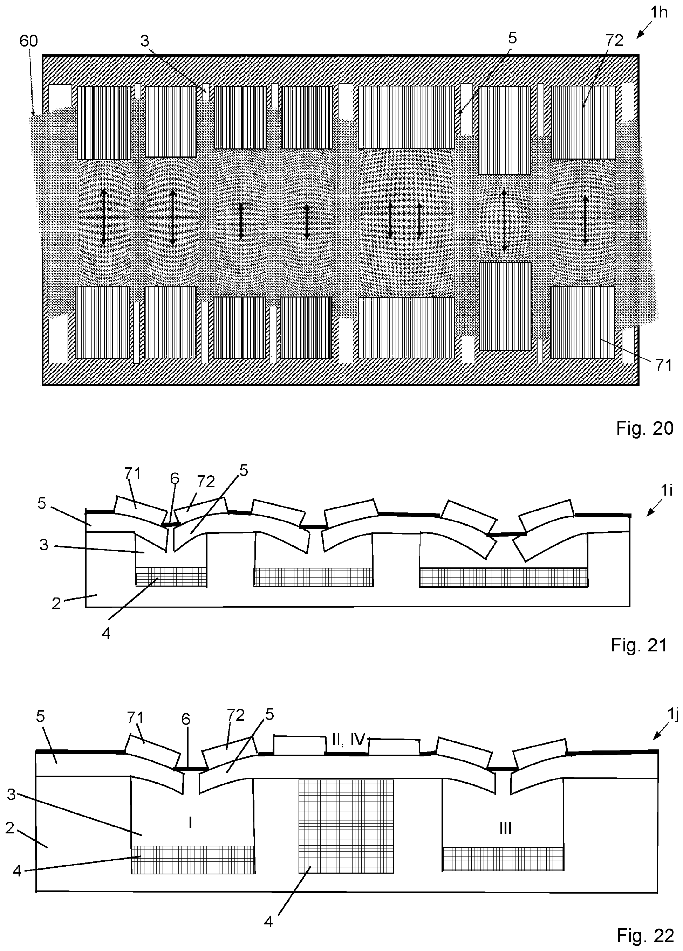

Figur 20 zeigt schematisch eine weitere erfindungsgemäße nanoelektronische Bauelementstruktur 1h mit einer heterogen verzerrten Graphen-Schicht 60. Die Graphen-Schicht 60 weist eine kontinuierliche Gitterstruktur auf.

Figur 21 zeigt schematisch noch eine weitere erfindungsgemäße nanoelektronische Bauelementstruktur 1i in Form eines Arrays mit variablen Spannungszuständen in einem identischen Nanomaterial innerhalb einer Nanomaterialdomäne. In der gezeigten Ausführungsform sind die jeweiligen, die Kavitäten 3 überspannenden Nanostrukturen als entlang einer räumliche Achse aneinandergereihte, unterschiedlich verspannte Segmente ein und derselben 1D- oder 2D-Nanomaterialstruktur mit gezielt eingestellten Grundeigenschaften, wie Chiralität, Durchmesser und/oder MW/SW, ausgebildet. Die Geometrien der jeweils unter den Nanostrukturen befindlichen Kavitäten 3 sind unterschiedlich. Die einzelnen Segmente können durch je Segment frei einstellbaren Dehnungsgrad individuell in ihren Eigenschaften, wie z. B. hinsichtlich ihrer Bandlücke oder Schwingungsfrequenz, moduliert werden. Somit entsteht eine materialvarianzunabhängige, eindimensionale Aufreihung von unterschiedlichen Basiselementen der nanoelektronischen Bauelementstruktur 1i, die als geschlossene Einheit gesehen einer neuen Klasse von segmentspezifisch konfigurierbaren, multifunktionalen nanoelektronischen Bauelementstrukturen auf Bais von 1D- oder 2D-Nanomaterialsystemen angehört.

Durch die unterschiedlichen Verspannungen der Nanostrukturen 6 weisen diese eine gezielte Modifikation der Bandstruktur, wie z. B. der Bandlücke, auf. Diese kann so gestaltet sein, dass damit eine Modifikation der elektronischen Interaktion zwischen Adsorbanten oder Chemisorbanten und dem Nanomaterial der Nanostrukturen 6 einhergeht.

Die nanoelektronische Bauelementstruktur 1i kann daher beispielsweise als Biosensor genutzt werden, welcher aufgrund der Spezifika der verschiedenen Spannungszustände auf eine zu detektierenden Stoff diesen mittels Deep-Learning-Ansätzen identifizieren kann. Die nanoelektronische Bauelementstruktur 1i kann auch zur spezifischen Detektion von chemischen oder Gassubstanzen eingesetzt werden.

Dabei kann der jeweilige, auf Basis der vorliegenden Erfindung ausgebildete miniaturisierte biologische und/oder chemische Sensor und/oder Gassensor Empfindlichkeiten im Atommassenbereich aufweisen sowie massenspektral fungieren.

Als Messsignal der nanoelektronischen Bauelementstruktur 1i kann die Resonanzfrequenz der aufgespannten und verspannten Nanostrukturen 6 kapazitiv zwischen der jeweiligen Nanostruktur 6 und der Steuerelektrode 4 ausgelesen werden. Die Resonanzfrequenz lässt sich durch Modifikation der eingebrachten mechanischen Spannung kontrollieren und deswegen kann die Selektivität hinsichtlich Wechselwirkung mit einem bestimmten Stoff erzielt werden.

Der Messmechanismus kann beispielsweise auf einer Masseänderung wenigstens einer jeweils schwingenden Nanostruktur 6 der nanoelektronischen Bauelementstruktur 1i basieren, die sich dadurch ergibt, dass sich an der Nanostruktur 6 Atome oder Moleküle eines Stoffes anlagern.

Ferner können durch die unterschiedlich verspannten Nanostrukturen 6 bestimmte Spezies selektiv chemisorbiert werden.

In bestimmten Ausführungsformen der vorliegenden Erfindung können in oder an der wenigstens einen Nanostruktur 6 kleine Massekörper, vor oder nach deren Verspannung, vorgesehen werden. Dadurch können breitbandige Inertialsensoren mit einer Schwingungsdetektion oberhalb von 100 kHz sowie 3D-Beschleunigungen erzeugt werden.

Figur 22 zeigt schematisch eine erfindungsgemäße nanoelektronische Bauelementstruktur 1j in Form einer innerhalb einer Nanomaterialdomäne eines identischen Nanomaterials ausgebildeten Sensorhalbbrücke. Die Sensorhalbbrücke weist beispielsweise aufgrund zu detektierender Umwelteinflüsse, wie mechanischer und/oder optischer und/oder chemischer Umwelteinflüsse, veränderliche Diagonalelemente I und III und einstellbare Kompensationselemente II und IV auf. Die Halbbrückenschaltung ist monolithisch in ein und demselben Material, d. h. innerhalb einer Domäne, gefertigt und stellt somit eine höchst empfindliche, driftfreie Messschaltung dar. Die als Sensorelemente fungierenden Diagonalelemente I und III können bedingt durch die verwendete erfindungsgemäße Technologie für deren Verspannung eine Piezoresistivität mit einem ho**hen Gauge-Faktor** (z. B. von 400) aufweisen, während die beiden Kompensationselemente II und IV durch layoutbestimmtes Auslassen der Verspannstruktur unverspannt bleiben.

Die gezeigte Halbbrücke kann in stark miniaturisierter Form, beispielsweise auf einer Fläche < 10 µm², einschließlich der Halbbrückenverdrahtung Platz finden.

Mit derartigen nanoelektronischen Bauelementstrukturen können sowohl kleinste Stauchungen als auch Dehnungen piezoresistiv erfasst werden. Zudem können auf dieser Grundlage atomlagendünne 1D- oder 2D-Nanomaterial-basierte piezoresistive Sensoren in Vollbrückenkonfiguration realisiert werden.

## Patentansprüche

1. Zwischenprodukt (1a') zur Herstellung einer nanoelektronischen Bauelementstruktur (1a - 1j), wobei das Zwischenprodukt (1a') ein Substrat (2), wenigstens eine in dem Substrat (2) ausgebildete Kavität (3, 3a) und wenigstens eine die jeweilige Kavität (3, 3a) zumindest teilweise überspannende Nanostruktur (6, 6a) aufweist, wobei die Kavität (3, 3a) zumindest teilweise mit einem selektiv zum Material des Substrates (2) ätz- oder auflösbaren Opfermaterial (8) gefüllt ist und das Zwischenprodukt (1a') entweder wenigstens einseitig der jeweiligen Kavität (3, 3a) wenigstens einen die wenigstens eine Kavität (3, 3a) nur teilweise überspannenden Ausleger (5) aufweist, so dass über der wenigstens einen Kavität (3, 3a) eine Lücke (50) ausgebildet ist, oder wenigstens einen die Kavität (3, 3a) überspannenden Ausleger (5) mit einer über der wenigstens einen Kavität (3, 3a) ausgebildeten Sollbruchstelle aufweist, wobei die wenigstens eine Nanostruktur (6, 6a) auf dem wenigstens einen Ausleger (5), jeweils die Lücke (50) oder die Sollbruchstelle überspannend angeordnet ist und jeweils beidseitig der Lücke (50) oder der Sollbruchstelle von jeweils einer Kontaktelektrode (71, 72) überdeckt ist.

2. Zwischenprodukt nach Anspruch 1, **dadurch gekennzeichnet, dass** in wenigstens einer der wenigstens einen Kavität (3, 3a) wenigstens eine Steuerelektrode (4) angeordnet oder ausgebildet ist.

3. Nanoelektronische Bauelementstruktur (1a - 1j), die ein Substrat (2), wenigstens eine in dem Substrat (2) ausgebildete Kavität (3, 3a) und wenigstens eine die jeweilige Kavität (3, 3a) zumindest teilweise überspannende Nanostruktur (6, 6a) aufweist, wobei die nanoelektronische Bauelementstruktur (1a - 1j) wenigstens einseitig der jeweiligen Kavität (3, 3a) wenigstens einen die wenigstens eine Kavität (3, 3a) nur teilweise überspannenden Ausleger (5) aufweist, so dass über der wenigstens einen Kavität (3, 3a) eine Lücke (50) ausgebildet ist, wobei die wenigstens eine Nanostruktur (6, 6a) auf dem wenigstens einen Ausleger (5), jeweils die Lücke (50) überspannend angeordnet ist und zwischen dem wenigstens einen Ausleger (5) und jeweils beidseitig der Lücke (50) ausgebildeten Kontaktelektroden (71, 72) fixiert ist,
und wobei der wenigstens eine Ausleger an seinem über oder in die jeweilige Kavität (3, 3a) ragenden Auslegerende (51, 52) gebogen oder geschrumpft ist, so dass die wenigstens eine Nanostruktur (6, 6a) auf Zug gespannt ist.

4. Nanoelektronische Bauelementstruktur nach Anspruch 3, **dadurch gekennzeichnet, dass** die wenigstens eine Nanostruktur (6, 6a) zwischen den Kontaktelektroden (71, 72) mechanisch auf Zug gespannt ist.

5. Nanoelektronische Bauelementstruktur nach einem der Ansprüche 3 oder 4, **dadurch gekennzeichnet, dass** in wenigstens einer der wenigstens einen Kavität (3, 3a) wenigstens eine Steuerelektrode (4) angeordnet ist.

6. Nanoelektronische Bauelementstruktur nach einem der Ansprüche 3 bis 5, **dadurch gekennzeichnet, dass** das Substrat (2) eine Mehrzahl der Kavitäten (3, 3a) aufweist, die jeweils von wenigstens einer der Nanostrukturen (6, 6a) überspannt sind, wobei wenigstens zwei der Kavitäten (3, 3a) unterschiedliche Breiten und/oder Tiefen und/oder Längen aufweisen und/oder wenigstens zwei der Nanostrukturen (6, 6a) unterschiedliche Breiten und/oder Längen aufweisen und/oder wenigstens zwei der Nanostrukturen (6, 6a) in unterschiedliche Raumrichtungen ausgerichtet und/oder mechanisch gespannt sind.

7. Nanoelektronische Bauelementstruktur nach einem der Ansprüche 3 bis 6, **dadurch gekennzeichnet, dass** sich wenigstens in der wenigstens einen Kavität (3, 3a) ein geschrumpftes Füllmaterial (90) befindet, auf dem wenigstens ein Auslegerende (51, 52) des jeweiligen Auslegers (5) aufliegt oder in das wenigstens ein Auslegerende (51, 52) des jeweiligen Auslegers (5) eingebunden ist.

8. Nanoelektronische Bauelementstruktur nach einem der Ansprüche 3 bis 7, **dadurch gekennzeichnet, dass** in die wenigstens eine Kavität (3, 3a) ragende Auslegerenden (51, 52) durch ein in die jeweilige Kavität (3, 3a) eingebrachtes Füllmaterial (9) fixiert sind.

9. Nanoelektronische Bauelementstruktur nach einem der Ansprüche 3 bis 8, **dadurch gekennzeichnet, dass** an der wenigstens einen Nanostruktur (6, 6a) jeweils wenigstens ein Massekörper angeordnet ist.

10. Verfahren zum Herstellen einer nanoelektronischen Bauelementstruktur (1a - 1j), bei dem in ein Substrat (2) wenigstens eine Kavität (3, 3a) eingebracht wird und die jeweilige Kavität (3, 3a) mit wenigstens einer Nanostruktur (6, 6a) überbrückt wird, wobei die wenigstens eine Kavität (3, 3a) wenigstens teilweise mit einem Opfermaterial (8) gefüllt wird, auf der wenigstens teilweise mit dem Opfermaterial (8) gefüllten Kavität (3, 3a) entweder wenigstens einseitig der jeweiligen Kavität (3, 3a) wenigstens ein die wenigstens eine Kavität (3, 3a) nur teilweise überspannender Ausleger (5) ausgebildet wird, so dass über der wenigstens einen Kavität (3, 3a) eine Lücke (50) ausgebildet ist, oder wenigstens ein die jeweilige Kavität (3, 3a) überspannender Ausleger (5) mit einer Sollbruchstelle über der wenigstens einen Kavität (3, 3a) ausgebildet wird, die wenigstens eine Nanostruktur (6, 6a) auf dem wenigstens einen Ausleger (5), die jeweilige Lücke (50) oder Sollbruchstelle überspannend ausgebildet oder angeordnet wird, auf beidseitig der jeweiligen Kavität (3, 3a) ausgebildeten Nanostrukturenden (61, 62) der jeweiligen Nanostruktur (6, 6a) jeweils eine Kontaktelektrode (71, 72) ausgebildet wird, nachfolgend das Opfermaterial (8) aus der jeweiligen Kavität (3, 3a) zumindest teilweise herausgeätzt oder herausgelöst wird und, falls vorhanden, die Sollbruchstelle durchbrochen wird.

11. Verfahren nach Anspruch 10, **dadurch gekennzeichnet, dass** wenigstens ein Auslegerende (51, 52) des wenigstens einen Auslegers (5) mittels Tempern geschrumpft wird.

12. Verfahren nach einem der Ansprüche 10 oder 11, **dadurch gekennzeichnet, dass** in wenigstens einer der wenigstens einen Kavität (3, 3a), bevor diese mit dem Opfermaterial (8) zumindest teilweise gefüllt wird, wenigstens eine Steuerelektrode (4) angeordnet oder ausgebildet wird.

13. Verfahren nach einem der Ansprüche 10 bis 12, **dadurch gekennzeichnet, dass** wenigstens zwei der Kavitäten (3, 3a) jeweils mit unterschiedlichen Breiten und/oder Tiefen und/oder Längen ausgebildet werden und/oder wenigstens zwei der Nanostrukturen (6, 6a) in jeweils unterschiedliche Raumrichtungen ausgerichtet ausgebildet werden und/oder in jeweils unterschiedliche Raumrichtungen mechanisch gespannt werden.

14. Verfahren nach Anspruch 10, **dadurch gekennzeichnet, dass** nach dem zumindest teilweisen Herausätzen oder Herauslösen des Opfermaterials (8) aus der wenigstens einen Kavität (3, 3a) in die jeweilige Kavität (3, 3a) wenigstens ein Füllmaterial (90) eingebracht und dieses nachfolgend durch Tempern und/oder Aushärten geschrumpft wird.

15. Verfahren nach einem der Ansprüche 10 bis 14, **dadurch gekennzeichnet, dass** an der wenigstens einen Nanostruktur (6, 6a) jeweils wenigstens ein Massekörper ausgebildet wird, der aus dem wenigstens einen Ausleger (5) während des zumindest teilweisen Herausätzens oder Herauslösens des Opfermaterials (8) aus der wenigstens einen Kavität (3, 3a) ausgebildet wird.

## Claims

1. Intermediate product (1a') for producing a nanoelectronic component structure (1a - 1j), the intermediate product (1a') comprising a substrate (2), at least one cavity (3, 3a) formed in the substrate (2) and at least one nanostructure (6, 6a) which at least partially traverses the corresponding cavity (3, 3a), the cavity (3, 3a) being at least partially filled with a sacrificial material (8) which is selectively etchable or dissolvable relative to the material of the substrate (2) and the intermediate product (1a') either comprises at least one arm (5) on at least one side of the corresponding cavity (3, 3a) which partially traverses the at least one cavity (3, 3a) so that a gap (50) is formed above the at least one cavity (3, 3a), or comprises at least one arm (5) traversing the cavity (3, 3a) with a predetermined breaking point formed above the at least one cavity (3, 3a), the at least one nanostructure (6, 6a) being arranged on the at least one arm (5), respectively traversing the gap (50) or the predetermined breaking point, and being covered by one contact electrode (71, 72) respectively on both sides of the gap (50) or the predetermined breaking point.

2. Intermediate product according to claim 1, **characterized in that** at least one control electrode (4) is arranged or formed in at least one of the at least one cavity (3, 3a)

3. Nanoelectronic component structure (1a - 1j) comprising a substrate (2), at least one cavity (3, 3a) formed in the substrate (2) and at least one nanostructure (6, 6a) which at least partially traverses the respective cavity (3, 3a), wherein the nanoelectronic component structure (1a - 1j) comprises at least one arm (5) which at least on one side of the corresponding cavity (3, 3a) partially traverses the at least one cavity (3, 3a) so that a gap (50) is formed over the at least one cavity (3, 3a), the at least one nanostructure (6, 6a) being arranged on the at least one arm (5) respectively traversing the gap (50) and being fixed between the at least one arm (5) and contact electrodes (71, 72) respectively formed on both sides of the gap (50), and wherein the at least one arm is bent or shrunk on its arm end (51, 52) projecting over or into the respective cavity (3, 3a), so that the at least one nanostructure (6, 6a) is tensioned.

4. Nanoelectronic component structure according to claim 3, **characterized in that** the at least one nanostructure (6, 6a) is mechanically tensioned between the contact electrodes (71, 72).

5. Nanoelectronic component structure according to one of claims 3 or 4, **characterized in that** at least one control electrode (4) is arranged in at least one of the at least one cavity (3, 3a).

6. Nanoelectronic component structure according to one of claims 3 to 5, **characterized in that** the substrate (2) comprises a plurality of the cavities (3, 3a) which each are traversed by at least one of the nanostructures (6, 6a), wherein at least two of the cavities (3, 3a) have different widths and/or depths and/or lengths and/or at least two of the nanostructures (6, 6a) have different widths and/or lengths and/or at least two of the nanostructures (6, 6a) are aligned and/or mechanically tensioned in different spatial directions.

7. Nanoelectronic component structure according to one of claims 3 to 6, **characterized in that** a shrunk filler material (90) is located at least in the at least one cavity (3, 3a), wherein at least one arm end (51, 52) of the respective arm (5) rests on the shrunk filler material (90) or the at least one arm end (51, 52) of the respective arm (5) is incorporated in the shrunk filler material (90).

8. Nanoelectronic component structure according to one of claims 3 to 7, **characterized in that** arm ends (51, 52) projecting into the at least one cavity (3, 3a) are fixed by a filler material (9) introduced into the corresponding cavity (3, 3a).

9. Nanoelectronic component structure according to one of claims 3 to 8, **characterized in that** at least one mass body is respectively arranged on the at least one nanostructure (6, 6a).

10. Method for producing a nanoelectronic component structure (1a - 1j), in which at least one cavity (3, 3a) is introduced into a substrate (2) and the respective cavity (3, 3a) is bridged by at least one nanostructure (6, 6a), wherein the at least one cavity (3, 3a) is at least partially filled with a sacrificial material (8), on the cavity (3, 3a) at least partially filled with the sacrificial material (8) either at least on one side of the corresponding cavity (3, 3a) at least one arm (5) is formed which only partially traverses the at least one cavity (3, 3a), so that a gap (50) is formed above the at least one cavity (3, 3a), or at least one arm (5) traversing the respective cavity (3, 3a) with a predetermined breaking point is formed above the at least one cavity (3, 3a), the at least one nanostructure (6, 6a) is formed or arranged on the at least one arm (5) so as to traverse the respective gap (50) or predetermined breaking point, a contact electrode (71, 72) is respectively formed on respective nanostructure ends (61, 62) of the respective nanostructure (6, 6a) formed on both sides of the corresponding cavity (3, 3a), subsequently the sacrificial material (8) is at least partially etched out or dissolved out of the corresponding cavity (3, 3a), and, if present, the predetermined breaking point is broken through.

11. Method according to claim 10, **characterized in that** at least one arm end (51, 52) of the at least one arm (5) is shrunk by means of tempering.

12. Method according to one of claims 10 to 11, **characterized in that** at least one control electrode (4) is arranged or formed in at least one of the at least one cavity (3, 3a) before said cavity is at least partially filled with the sacrificial material (8).

13. Method according to one of claims 10 to 12, **characterized in that** at least two of the cavities (3, 3a) are formed with different widths and/or depths and/or lengths and/or at least two of the nanostructures (6, 6a) are formed aligned to different spatial directions and/or are mechanically tensioned into different spatial directions respectively.

14. Method according to claim 10, **characterized in that**, after at least partially etching or dissolving the sacrificial material (8) out of the at least one cavity (3, 3a), at least one filler material (90) is introduced into the respective cavity (3, 3a) and said material is subsequently shrunk by tempering and/or curing.

15. Method according to one of claims 10 to 14, **characterized in that** at least one mass body is formed on the at least one nanostructure (6, 6a), which is formed from the at least one arm (5) when the sacrificial material (8) is at least partially etched or dissolved out of the at least one cavity (3, 3a).

## Revendications

1. Produit intermédiaire (1a') pour la production d'une structure de composant nanoélectronique (1a - 1j), le produit intermédiaire (1a') comprenant un substrat (2), au moins une cavité (3, 3a) formée dans le substrat (2) et au moins une nanostructure (6, 6a) enjambant au moins partiellement la cavité (3, 3a) respective, la cavité (3, 3a) étant au moins partiellement remplie d'un matériau sacrificiel (8) sélectivement cautérisable ou éluble par rapport au matériau du substrat (2), et le produit intermédiaire (1a') présentant soit au moins une saillie (5) sur au moins un côté de la cavité (3, 3a) respective, qui l'enjambe seulement partiellement ainsi qu'un espace (50) est formé au-dessus de l'au moins une cavité (3, 3a), soit au moins une saillie (5) enjambante la cavité (3, 3a) avec un point de rupture prédéterminé sur l'au moins une cavité (3, 3a), l'au moins une nanostructure (6, 6a) étant disposée sur l'au moins une saillie (5) respectivement enjambant l'espace (50) ou le point de rupture prédéterminé et étant recouverte des deux côtés de l'espace (50) ou du point de rupture prédéterminé par une électrode de contact (71, 72) respectivement.

2. Produit intermédiaire selon la revendication 1, **caractérisé en ce que** au moins une électrode de commande (4) est disposée ou formée dans au moins une des au moins une cavité (3, 3a).

3. Structure de composant nanoélectronique (1a - 1j) comprenant un substrat (2), au moins une cavité (3, 3a) formée dans le substrat (2) et au moins une nanostructure (6, 6a) enjambant au moins partiellement la cavité (3, 3a) respective, la structure de composant nanoélectronique (1a - 1j) comportant au moins d'un seul côté de la cavité (3, 3a) respective au moins une saillie (5) enjambant seulement partiellement l'au moins une cavité (3, 3a), ainsi qu'un espace (50) est formé au-dessus l'au moins une cavité (3, 3a), l'au moins une structure (6, 6a) étant disposée sur l'au moins une saillie (5), enjambant l'espace (50) respective et étant fixée entre l'au moins une saillie (5) et des electrodes de contact (71, 72) formées des deux côtés de l'esapce (50), et l'au moins une saillie étant pliée ou rétrécie à son bout de saillie (51, 52) s'élevant sur ou dans la cavité (3, 3a) respective, ainsi que l'au moins une nanostructure (6, 6a) est en un état de tension.

4. Structure de composant nanoélectronique selon la revendication 3, **caractérisée en ce que** l'au moins une nanostructure (6, 6a) est mécaniquement tendue entre les électrodes de contact (71, 72).

5. Structure de composant nanoélectronique selon l'une des revendications 3 ou 4, **caractérisée en ce que** au moins une électrode de commande (4) est disposée dans au moins une de l'au moins une cavité (3, 3a).

6. Structure de composant nanoélectronique selon l'une des revendications 3 à 5, **caractérisée en ce que** le substrat (2) comporte une pluralité de cavités (3, 3a), chacune étant enjambée par au moins une des nanostructures (6, 6a), au moins deux des cavités (3, 3a) comprenant des largeurs et/ou des profondeurs et/ou des longueurs différentes et/ou au moins deux des nanostructures (6, 6a) comprenant des largeurs et/ou des longueurs différentes et/ou au moins deux des nanostructures (6, 6a) étant orientées et/ou étant mécaniquement tendues dans des directions spatiales différentes.

7. Structure de composant nanoélectronique selon l'une des revendications 3 à 6, **caractérisée en ce que** un matériau de remplissage rétréci (90) est situé au moins dans l'au moins une cavité (3, 3a), sur lequel l'au moins un bout de saillie (51, 52) de la saillie (5) respective repose, ou dans lequel l'au moins un bout de saillie (51, 52) de la saillie (5) respective est intégré.

8. Structure de composant nanoélectronique selon l'une des revendications 3 à 7, **caractérisée en ce que** les bouts de saillie (51, 52) s'élevant dans l'au moins une cavité (3, 3a) sont fixées par un matériau de remplissage (9) introduit dans la cavité (3, 3a) respective.

9. Structure de composant nanoélectronique selon l'une des revendications 3 à 8, **caractérisée en ce que** au moins un corps massif est disposé sur l'au moins une nanostructure (6, 6a).

10. Procédé de production d'une structure de composant nanoélectronique (1a - 1j) dans lequel au moins une cavité (3, 3a) est introduite dans un substrat (2) et cette cavité (3, 3a) est enjambée par au moins une nanostructure (6, 6a), l'au moins une cavité (3, 3a) étant au moins partiellement remplie d'un matériau sacrificiel (8), soit au moins une saillie (5) enjambante seulment partiellement l'au moins une cavité (3, 3a) est formée sur au moins un côté de la cavité (3, 3a) respective au moins partiellement remplie de matériau sacrificiel (8), ainsi qu'un espace (50) est formé sur l'au moins une cavité (3, 3a), soit au moins une saillie (5) enjambante la cavité (3, 3a) respective avec un point de rupture prédéterminé est formée sur l'au moins une cavité (3, 3a), l'au moins une nanostructure (6, 6a) est formée ou disposée sur l'au moins une saillie (5) enjambant l'espace (50) ou le point de rupture prédéterminé, une électrode de contact (71, 72) est formée sur des bouts de nanostructure (61, 62) formés des deux côtés de la cavité (3, 3a) respective, ci-après le matériau sacrificial (8) est cautérisé ou élué au moins partiellement hors de la cavité (3, 3a) respective, et, s'il est présent, le point de rupture prédéterminé est rompu.

11. Procédé selon la revendication 10, **caractérisé en ce que** au moins un bout de saillie (51, 52) de l'au moins une saillie (5) est rétréci par recuit.

12. Procédé selon l'une des revendications 10 ou 11, **caractérisé en ce que** au moins une électrode de commande (4) est disposée ou formée dans au moins une de l'au moins une cavité (3, 3a) avant d'être au moins partiellement remplie avec le matériau sacrificiel (8).

13. Procédé selon l'une des revendications 10 à 12, **caractérisé en ce que** au moins deux des cavités (3, 3a) sont chacune formées avec des largeurs et/ou des profondeurs et/ou des longueurs différentes et/ou au moins deux des nanostructures (6, 6a) sont formées orientées dans des directions spatiales différentes et/ou sont fixées mécaniquement dans des directions spatiales différentes.

14. Procédé selon la revendication 10, **caractérisé en ce que**, après cautériser ou éluer le matériau sacrificiel (8) au moins partiellement hors de l'au moins une cavité (3, 3a) au moins un matériau de remplissage (90) est introduit dans la cavité respective (3, 3a) et puis est rétréci par recuit et/ou durcissement.

15. Procédé selon l'une des revendications 10 à 14, **caractérisé en ce que** au moins un corps massif est formé sur l'au moins une nanostructure (6, 6a), qui est formé sur l'au moins une saillie (5) lors de cautériser ou éluer le matériau sacrificiel (8) au moins partiellement hors de l'au moins une cavité (3, 3a).
